(19) Europäisches Patentamt
European Patent Office
Office européen des brevets

(11) EP 2 366 752 B1

# (12) EUROPÄISCHE PATENTSCHRIFT

(45) Veröffentlichungstag und Bekanntmachung des Hinweises auf die Patenterteilung:
**20.07.2016 Patentblatt 2016/29**

(21) Anmeldenummer: **10015929.2**

(22) Anmeldetag: **21.10.2004**

(51) Int Cl.:
***C09K 11/06*** *(2006.01)*
***C07F 15/00*** *(2006.01)*
***C08L 65/00*** *(2006.01)*
***C08G 61/04*** *(2006.01)*
***H01L 51/00*** *(2006.01)*
***H01L 51/30*** *(2006.01)*
***C08G 61/00*** *(2006.01)*
***C08G 61/02*** *(2006.01)*
***C09B 69/10*** *(2006.01)*
***H01L 51/50*** *(2006.01)*

## (54) NEUE MATERIALIEN FÜR DIE ELEKTROLUMINESZENZ UND DEREN VERWENDUNG

NEW MATERIALS FOR ELECTROLUMINESCENCE AND USE OF SAME

NOUVEAUX MATÉRIAUX POUR L'ÉLECTROLUMINESCENCE ET LEUR UTILISATION

(84) Benannte Vertragsstaaten:
**AT BE BG CH CY CZ DE DK EE ES FI FR GB GR HU IE IT LI LU MC NL PL PT RO SE SI SK TR**

(30) Priorität: **22.10.2003 DE 10349033**
**20.01.2004 DE 102004003008**

(43) Veröffentlichungstag der Anmeldung:
**21.09.2011 Patentblatt 2011/38**

(62) Dokumentnummer(n) der früheren Anmeldung(en) nach Art. 76 EPÜ:
**04790695.3 / 1 675 930**

(73) Patentinhaber: **Merck Patent GmbH**
**64293 Darmstadt (DE)**

(72) Erfinder:
- **Heun, Susanne, Dr.**
**65812 Bad Soden (DE)**
- **Scheurich, René Peter, Dr.**
**64846 Gross-Zimmern (DE)**
- **Buesing, Arne, Dr.**
**65929 Frankfurt am Main (DE)**
- **Ludemann, Aurélie, Dr.**
**60322 Frankfurt am main (DE)**
- **Gerhard, Anja, Dr.**
**63329 Egelsbach (DE)**
- **Stoessel, Philipp, Dr.**
**60487 Frankfurt am Main (DE)**
- **Vestweber, Horst, Dr.**
**34630 Gilserberg-Winterscheid (DE)**

(56) Entgegenhaltungen:
**WO-A2-01/91203**

- **V. CLEAVE ET.AL.: "Harvesting singlet and triplet energy in polymer LEDs", ADV. MATER., Bd. 11, Nr. 4, 1999, Seiten 285-288, XP002316107,**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 366 752 B1

## Beschreibung

Die vorliegende Erfindung beschreibt neue Materialien und Materialmischungen für die Verwendung in organischen elektronischen Bauteilen und deren Verwendung in darauf basierenden Displays.

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in WO 90/13148 offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6). Aus theoretischen Überlegungen ist unter Verwendung solcher Triplett-Emitter eine bis zu vierfache Energie- und Leistungseffizienz möglich. Ob sich diese Entwicklung allerdings durchsetzen wird, hängt stark davon ab, ob entsprechende Device-Kompositionen gefunden werden können, die diese Vorteile auch in OLEDs umsetzen können. Als wesentliche Bedingungen für die praktische Anwendbarkeit sind hier insbesondere ein effizienter Energieübertrag auf den Triplett-Emitter (und damit verbunden effiziente Lichtemission), eine hohe operative Lebensdauer und eine niedrige Einsatz- und Betriebsspannung zu nennen. Um dies zu erreichen, sind außer den Eigenschaften des Triplett-Emitters auch die Eigenschaften des Matrixmaterials von herausragender Bedeutung. Während hierfür lange Zeit vor allem Carbazolverbindungen in Betracht gezogen wurden und erste gute Ergebnisse zeigten, wurden vor kurzem mit neuen Matrixmaterialien, basierend auf Keto- und Iminverbindungen (nicht offen gelegte Anmeldung DE 10317556.3) oder auf Phosphinoxiden, Sulfonen und Sulfoxiden (nicht offen gelegte Anmeldung DE 10330761.3), hervorragende Ergebnisse sowohl in Bezug auf die Effizienz, wie auch auf die Lebensdauer der Devices erzielt.

In letzter Zeit gibt es zunehmend Bemühungen, sich die oben genannten Vorteile aufdampfbarer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen des Triplett-Emitters in das Polymer entstehen. Andererseits kann der Triplett-Emitter auch kovalent an das Polymer gebunden werden. Beide Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (z. B. mit Hilfe hochauflösender Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie. Auch hier ist ein geeignetes Matrixmaterial notwendig, das einen effizienten Energietransfer auf den Triplett-Emitter ermöglicht und das in Verbindung mit diesem gute Lebensdauern bei niedrigen Betriebsspannungen aufweist.

In WO 04/070772 sind Blends und Copolymere von Triplett-Emittern mit bestimmten Carbazol-haltigen konjugierten Polymeren beschrieben, die in effizienter Emission und reduzierter Betriebsspannung resultieren. Eine weitere Verbesserung wurde durch die Einführung bestimmter überbrückter Carbazol-Einheiten erreicht, wie in der nicht offen gelegten Anmeldung DE 10328627.6 beschrieben.

V. Cleave et al. beschreibt in "Harvesting Singlet and Triplet Energy in Polymer LEDs" in Adv. Mater. 1999, Bd. 11, Nr. 4, S. 285-288 molekulare Halbleiter als emittierende Materialien in Leuchtdioden. Es werden hier organische Halbleiter vorgestellt, die auf einer Mischung aus Platin Octaethylporphyrin (PtOEP) als Triplett-Emitter in Poly[4-(N-4-vinylbenzyloxyethyl, *N*-methylamino)-*N*-(2,5-di-*tert*-butylphenylnaphthalimid (PNP) basieren. Die Gegenwart des Schwermetalls Platin in dem Porphyrin-System ermöglicht ein schnelles Intersystem-Crossing (ISC) in den Triplett-Zustand des PtOEP-Moleküls und eine anschließende Emission aus diesem Zustand.

Die WO 01/91203 A2 beschreibt ein lichtemittierendes Material und eine organische Elektrolumineszenzvorrichtung mit hoher Emissionseffizienz, wobei zwei organische Verbindungen, die zur Lichtemission beitragen, verwendet werden. Diese beiden organischen Verbindungen haben bezüglich ihrer Energieniveau im angeregten Zustand eine solche Beziehung, dass ein Energietransfer von dem angeregten Triplett-Zustand einer Verbindung auf den angeregten Triplett-Zustand der anderen Verbindung erfolgen kann. Die organische Elektrolumineszenzvorrichtung und das lichtemittierende Material zeichnen sich durch eine hohe Emissionseffizienz, Lumineszenz und Haltbarkeit aus. Sie umfasst eine lichtemittierende Schicht, die zwei oder mehrere organische Verbindungen enthält, wobei von diesen organischen Verbindungen zwei organische Verbindungen so konditioniert sind, dass das Energieniveau E1T2 einer ersten organischen Verbindung im niedrigsten angeregten Triplett-Zustand höher ist als das Energieniveau E2s1 einer zweiten organischen Verbindung in dem niedrigsten angeregten Singulett-Zustand, dass mindestens ein Energieniveau der zweiten organischen Verbindung in einem angeregten Triplett-Zustand zwischen E1T1 und E2s1 liegt und dass Licht von der zweiten organischen Verbindung emittiert wird.

Trotz der in den o. g. Publikationen und Anmeldeschriften zitierten Fortschritte gibt es jedoch immer noch

erhebliches Verbessungspotenzial für entsprechende Materialien auf dem Gebiet der aus Lösung verarbeitbaren Triplett-Emitter. U. a. auf folgenden Feldern ist weiterhin ein deutlicher Verbesserungsbedarf zu sehen:

(1) Die Effizienz der Elektrolumineszenzelemente muss gegenüber dem Stand der Technik weiter deutlich erhöht werden, um sie auf das Niveau der durch Aufdampfen erhaltenen Devices zu bringen.
(2) Die Lebensdauer der Elektrolumineszenzelemente ist gegenüber dem Stand der Technik deutlich zu erhöhen.
(3) Die Löslichkeit der Polymere und Blends mit den oben beschriebenen überbrückten Carbazol-Einheiten, die den nächstliegenden Stand der Technik darstellen, ist noch nicht immer zufriedenstellend. So ist es beispielsweise nicht möglich, einen hohen Anteil der dort beschriebenen überbrückten Carbazol-Einheiten einzupolymerisieren, da dies zu unlöslichen Polymeren führt. Für die Anwendung sind jedoch lösliche Polymere nötig.
(4) Die oben beschriebenen Carbazol-Einheiten zeigen zwar in der Anwendung schon recht gute Ergebnisse. Ein weiterer Nachteil dieser Einheiten, außer der eingeschränkten Löslichkeit, ist jedoch der teilweise sehr aufwändige chemische Zugang zu diesen Verbindungen. Hier wäre es wünschenswert, Verbindungen und Monomere zur Verfügung zu haben, deren Device-Eigenschaften vergleichbar oder besser sind, die aber leichter synthetisch zugänglich sind.
(5) Die Polymere und Mischungen gemäß dem Stand der Technik zeigen eine hohe Sauerstoffempfindlichkeit. So lassen sie sich nur unter sorgfältigem Ausschluss von Sauerstoff verarbeiten. Hier wären weniger empfindliche Substanzen deutlich von Vorteil.

Es ist also offensichtlich, dass hier weiterhin großer Verbesserungsbedarf besteht.
Überraschend wurde gefunden, dass Polymere und Mischungen, die bestimmte Struktureinheiten enthalten, in Kombination mit Triplett-Emittern hier deutliche Verbesserungen im Vergleich zu Mischungen oder Polymeren gemäß dem Stand der Technik ergeben. Diese Polymere und Mischungen sind durch Standardreaktionen leicht chemisch zugänglich oder teilweise sogar kommerziell erhältlich und führen im Allgemeinen zu gut löslichen Polymeren. Außerdem zeigen sie eine geringere Sauerstoffempfindlichkeit, was ihre Herstellung und Verarbeitung deutlich erleichtert. Sie sind daher Gegenstand der vorliegenden Anmeldung.
In WO 03/099901 gibt es eine zufällige Offenbarung eines an sich erfindungsgemäßen Copolymers aus einem Polymergrundgerüst, das Estergruppen (oder auch Carbonyl-, Sulfon-, Sulfoxid- oder Phosphinoxidgruppen) enthält, und einpolymerisierten Iridium- und Platin-Komplexen. Die Kombination solcher Polymergrundgerüste mit Triplett-Emittern sind demzufolge von der Erfindung ausgenommen.
In US 03/022908 und US 03/224208 gibt es eine zufällige Offenbarungen eines an sich erfindungsgemäßen Blends aus einem Polymer, das kovalent gebundene Triplett-Emitter enthält, und einem Ladungstransportpolymer, wobei zwei der aufgezeigten Ladungstransportpolymere (auf Basis von Triarylaminen) zusätzlich Keto- bzw. Sulfongruppen tragen. Besondere Vorteile dieser Kombination sind nicht aufgeführt. Diese Blends sind von der Erfindung ausgenommen.
Gegenstand der Erfindung sind organische Halbleiter, enthaltend

(A) 0.5 - 98.9 Gew.% eines beliebigen nicht-konjugierten Polymers (POLY3),
(B) 1 - 99 Gew.% mindestens einer Verbindung (VERB1), die mindestens eine Struktureinheit L=X enthält und in der Lage ist, bei Raumtemperatur glasartige Schichten zu bilden, wobei für die verwendeten Symbole gilt:

L ist bei jedem Auftreten gleich oder verschieden $(R^1)(R^2)C$, $(R^1)P$, $(R^1)As$, $(R^1)Sb$, $(R^1)Bi$, $(R^1)(R^2)(R^3)P$, $(R^1)(R^2)(R^3)As$, $(R^1)(R^2)(R^3)Sb$, $(R^1)(R^2)(R^3)Bi$, $(R^1)(R^2)S$, $(R^1)(R^2)Se$, $(R^1)(R^2)Te$, $(R^1)(R^2)S(=O)$, $(R^1)(R^2)Se(=O)$ oder $(R^1)(R^2)Te(=O)$;

X ist bei jedem Auftreten gleich oder verschieden O, S, Se oder N-$R^4$, mit der Maßgabe, dass X nicht S oder Se ist, wenn L für S, Se oder Te steht;

$R^1$, $R^2$, $R^3$ ist bei jedem Auftreten gleich oder verschieden H, F, CN, eine geradkettige, verzweigte oder cyclische Alkyl-, Alkoxy- oder Thioalkoxygruppe mit 1 bis 40 C-Atomen, die mit $R^5$ substituiert oder auch unsubstituiert sein kann, wobei ein oder mehrere H-Atome durch F, Cl, Br, I, CN oder $NO_2$ ersetzt sein können, oder ein aromatisches oder heteroaromatisches Ringsystem mit 1 bis 40 C-Atomen, das durch einen oder mehrere Reste $R^5$ substituiert sein kann, wobei zwei oder mehrere Substituenten $R^1$, $R^2$ und/oder $R^3$ auch miteinander ein mono- oder polycyclisches, aliphatisches oder aromatisches Ringsystem bilden können; dabei dürfen nicht alle Substituenten $R^1$ bis $R^3$ an einer Struktureinheit H oder F sein; die Gruppen $R^1$ bis $R^3$ können weiterhin gegebenenfalls Bindungen zum Polymer aufweisen;

$R^4$ ist bei jedem Auftreten gleich oder verschieden eine geradkettige, verzweigte oder cyclische Alkyl- oder Alkoxykette mit 1 bis 22 C-Atomen, in der ein oder mehrere nicht benachbarte C-Atome durch $-R^6C=CR^6-$, -C=C-, $Si(R^6)_2$, $Ge(R^6)_2$, $Sn(R^6)_2$, $-NR^6-$, -O-, -S-, -CO-O-, -O-CO-O- ersetzt sein können, wobei ein oder mehrere H-Atome durch Fluor ersetzt sein können, eine Aryl-, Heteroaryl- oder Aryloxygruppe mit 1 bis 40 C-Atomen, welche durch einen oder mehrere Reste $R^6$ substituiert sein kann, oder OH oder $N(R^5)_2$;

$R^5$ ist bei jedem Auftreten gleich oder verschieden $R^4$ oder CN, $B(R^6)_2$ oder $Si(R^6)_3$.

$R^6$ ist bei jedem Auftreten gleich oder verschieden H oder ein aliphatischer oder aromatischer Kohlenwasserstoffrest mit 1 bis 20 C-Atomen;

und

(C) 0.1 - 95 Gew.-% eines oder mehrerer Triplett-Emitter (TRIP1);

mit der Maßgabe, dass Mischungen aus zwei Polymeren ausgenommen sind, in denen das eine Polymer kovalent gebundene Triplett-Emitter enthält und das andere ein Copolymer aus Tetraphenyldiaminobiphenyl-Einheiten und Diphenylsulfonether- bzw. Diphenylketonether-Einheiten ist; und weiterhin mit der Maßgabe, dass Polymere, die einerseits kovalent gebundene Triplett-Emitter und andererseits Einheiten gemäß Formel (a) enthalten, von der Erfindung ausgenommen sind:

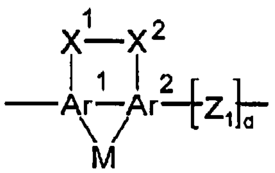

Formel (a)

worin $Ar^1$ und $Ar^2$ jeweils unabhängig eine tetravalente aromatische Kohlenwasserstoffgruppe oder eine tetravalente heterocyclische Gruppe bedeuten;

eine der Einheiten $X^1$ und $X^2$ bedeutet C(=O) oder $C(R^1)(R^2)$ und die andere bedeutet O, S, C(=O), S(=O), $SO_2$, $Si(R^3)(R^4)$, $N(R^5)$, $B(R^6)$, $P(R^7)$ oder $P(-O)(R^8)$;

wobei in der Formel (a) die Reste $R^1$, $R^2$, $R^3$, $R^4$, $R^5$, $R^6$, $R^7$ und $R^8$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine

Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten,

M bedeutet eine Gruppe, die durch Formel (b), Formel (c) oder Formel (d) dargestellt wird;

$$-Y^1-Y^2- \qquad \text{Formel (b)}$$

worin $Y^1$ und $Y^2$ jeweils unabhängig 0, S, C(=O), S(=O), $SO_2$, $C(R^9)(R^{10})$, $Si(R^{11})(R^{12})$, $N(R^{13})$, $B(R^{14})$, $P(R^{15})$ oder $P(=O)(R^{16})$ bedeuten,

wobei in der Formel (b) die Reste $R^9$, $R^{10}$, $R^{11}$, $R^{12}$, $R^{13}$, $R^{14}$, $R^{15}$ und $R^{16}$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arythiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten,

wobei $Y^1$ und $Y^2$ nicht identisch sind, wenn $Y^1$ nicht $C(R^9)(R^{10})$ oder $Si(R^{11})(R^{12})$ ist ;

$$-Y^3-Y^4- \qquad \text{Formel (c)}$$

worin $Y^3$ und $Y^4$ jeweils unabhängig N, B, P, $C(R^{17})$ oder $Si(R^{18})$ bedeuten; in der Formel (c) die Reste $R^{17}$ und $R^{18}$ jeweils unabhängig ein Wasserstoffatom, ein Halogenatom, eine Alkylgruppe, eine Alkoxygruppe,

eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe,

eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten;

$-Y^5-$ Formel (d)

$-Y^5-$ Formel (d)

worin $Y^5$ O, S, C(=O), S(=O), $SO_2$, $C(R^{19})(R^{20})$, $Si(R^{21})(R^{22})$, $N(R^{23})$, $B(R^{24})$, $P(R^{25})$ oder $P(=O)(R^{26})$ bedeutet;

wobei in de Formel (d) die Reste $R^{19}$, $R^{20}$, $R^{21}$, $R^{22}$, $R^{23}$, $R^{24}$, $R^{25}$ und $R^{26}$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten;
$Z_1$ bedeutet $-CR^{36}=CR^{37}-$ oder -CΞC-; $R^{36}$ und $R^{37}$ bedeuten jeweils unabhängig ein Wasserstoffatom, eine Alkylgruppe, eine Arylgruppe, eine monovalente heterocyclische Gruppe oder eine Cyanogruppe; d bedeutet 0 oder 1.

Das oben und im Folgenden verwendete Symbol "=" steht für eine Doppelbindung im Sinne der Lewis-Schreibweise.

Bevorzugte Struktureinheiten L=X, wie sie oben beschrieben sind, sind also ausgewählt aus den Formeln (1) bis (5),

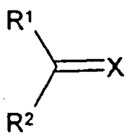
Formel (1)

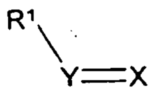
Formel (2)

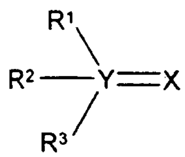
Formel (3)

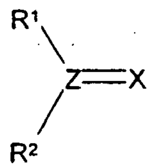
Formel (4)

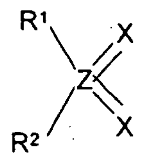
Formel (5)

wobei die verwendeten Symbole folgende Bedeutung haben:

- X ist bei jedem Auftreten gleich oder verschieden O, S, Se oder $N-R^4$, mit der Maßgabe, dass X für Formel (4) und (5) nicht S oder Se sein darf;
- Y ist bei jedem Auftreten gleich oder verschieden P, As, Sb oder Bi;
- Z ist bei jedem Auftreten gleich oder verschieden S, Se oder Te;
- $R^1$ bis $R^6$ haben dieselbe Bedeutung, wie oben beschrieben.

Die erfindungsgemäßen organischen Halbleiter liegen vorzugsweise als amorphe Verbindungen bzw. amorphe Mischungen vor.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (< 10 % der von H verschiedenen Atome, bevorzugt < 5 % der von H verschiedenen Atome), wie z. B. ein $sp^3$-hybridisiertes C-, N- oder O-Atom, unterbrochen sein können. So sollen also beispielsweise auch Systeme wie 9,9'-Spirobifluoren, 9,9-Diarylfluoren, Triarylamin, etc. als aromatische Ringsysteme im Sinne dieser Anmeldung verstanden werden.

Organische Halbleiter im Sinne dieser Anmeldung sind niedermolekulare, oligomere, dendritische oder polymere, organische oder metallorganische Verbindungen, die als Feststoff bzw. als Schicht halbleitende Eigenschaften aufweisen, d. h. bei denen die Energielücke zwischen Leitungs- und Valenzband zwischen 1.0 und 3.5 eV liegt. Als organischer Halbleiter wird hier entweder eine Reinkomponente oder eine Mischung von zwei oder mehreren Komponenten, von denen mindestens eine halbleitende Eigenschaften aufweisen muss, bezeichnet. Bei der Verwendung von Mischungen ist es jedoch nicht notwendig, dass jede der Komponenten halbleitende Eigenschaften aufweist. So können beispielsweise auch elektronisch inerte Verbindungen, wie z. B. Polystyrol, zusammen mit halbleitenden Verbindungen verwendet werden.

In einer bevorzugten Ausführungsform der Erfindung liegt der organische Halbleiter als eine Mischung vor. In einer weiteren bevorzugten Ausführungsform der Erfindung liegt der organische Halbleiter als ein Copolymer vor.

Unter einem Triplett-Emitter im Sinne der Erfindung soll eine Verbindung verstanden werden, die aus dem Triplett-Zustand Licht emittiert, also in der Elektrolumineszenz Phosphoreszenz statt Fluoreszenz zeigt, bevorzugt ein metallorganischer Triplett-Emitter. Diese Verbindung kann prinzipiell niedermolekular, oligomer, dendritisch oder polymer sein. Ohne an eine spezielle Theorie gebunden sein zu wollen, werden im Sinne dieser Anmeldung alle emittierenden Verbindungen, die die Elemente Ru, Os, Rh, Ir, Pd, Pt enthalten, als Triplett-Emitter bezeichnet.

Bei den erfindungsgemäßen organischen Halbleitern gibt es verschiedene Ausführungsformen, bei denen die Einheiten L=X, bzw. Einheiten gemäß Formel (1) bis (5) und/oder der Triplett-Emitter entweder eingemischt oder kovalent an das Polymer gebunden sind.

Die organischen Halbleiter dieser Erfindung enthalten:

(A) 0.5 - 98.9 Gew.% eines beliebigen nicht-konjugierten Polymers (POLY3);

(B) 1 - 99 Gew.% mindestens einer Verbindung (VERB1), die mindestens eine Struktureinheit L=X, bzw. mindestens eine Struktureinheit der Formel (1) bis (5) enthält und in der Lage ist, bei Raumtemperatur glasartige Schichten zu bilden, bevorzugt mit einer Glasübergangstemperatur größer 70 °C;

und außerdem

(C) 0.1 - 95 Gew.%, bevorzugt 0.5 - 80 Gew.%, besonders bevorzugt 1 - 50 Gew,%, insbesondere 2 - 25 Gew.% eines oder mehrerer Triplett-Emitter (TRIP1),

wobei die weiteren Merkmale aus Anspruch 1 gelten.

Die Polymere POLY3 sind nicht-konjugiert, d.h. sie sind weder konjugiert, teilkonjugiert noch, gekreuzt-konjugiert.

Konjugierte Polymere im Sinne dieser Erfindung sind Polymere, die in der Hauptkette hauptsächlich $sp^2$-hybridisierte (bzw. auch sp-hybridisierte) Kohlenstoffatome enthalten, die auch durch entsprechende Heteroatome ersetzt sein können und deren Einheiten miteinander in Konjugation stehen. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Einheiten gemäß TRIP2 (Konjugation über das Metallatom), befinden.

Teilkonjugierte Polymere im Sinne dieser Erfindung sind Polymere, die entweder in der Hauptkette längere konjugierte Abschnitte enthalten, die durch nicht-konjugierte Abschnitte unterbrochen werden, oder die in den Seitenketten eines in der Hauptkette nicht-konjugierten Polymeres längere konjugierte Abschnitte enthalten.

Gekreuzt-konjugierte Polymere im Sinne dieser Erfindung sind Polymere, in denen zwei konjugierte Abschnitte nicht miteinander in Konjugation treten, jeder einzelne dieser Abschnitte aber mit einer dritten Einheit konjugiert ist. Dies ist beispielsweise der Fall, wenn zwei konjugierte.Abschnitte direkt über eine Ketogruppe, eine Sulfoxidgruppe, eine Sulfongruppe oder eine Phosphinoxidgruppe verknüpft sind, aber beispielsweise auch bei geminaler Verknüpfung zweier konjugierter Abschnitte über eine substituierte oder unsubstituierte Alkengruppe oder bei Verknüpfung zweier konjugierter Abschnitte über beispielsweise eine meta-Phenylengruppe.

Hingegen würden Einheiten, wie beispielsweise einfache Alkylenketten, (Thio)Etherbrücken, Ester-, Amid- oder Imidverknüpfungen eindeutig als nicht-konjugierte Segmente definiert.

Die Polymere POLY3 können verschiedene weitere Strukturelemente enthalten. Diese können beispielsweise Struktureinheiten sein, die das Polymergrundgerüst bilden können, oder Struktureinheiten, die die Ladungsinjektions- bzw. Ladungstransporteigenschaften beeinflussen. Solche Einheiten sind beispielsweise in WO 03/020790 und in der nicht offen gelegten Anmeldung DE 10337346.2 ausführlich beschrieben.

Für die nichtkonjugierten Polymere POLY3 kommen prinzipiell beliebige Verbindungsklassen in Frage, sofern die Polymere, wenn sie als Blend verarbeitet werden, eine ausreichende Löslichkeit in einem Lösemittel oder einem Lösemittelgemisch aufweisen, in dem auch die anderen Blendbestandteile löslich sind, so dass alle Komponenten gemeinsam aus Lösung verarbeitet werden können.

Als Beispiele für nicht-konjugierte Polymere POLY3, die weder Einheiten L=X noch Triplett-Emitter kovalent gebunden enthalten, kommen beispielsweise Polymere in Frage, die sich im weitesten Sinne von Polyethylen bzw. Polystyrol ableiten, aber auch elektronisch aktive, nicht-konjugierte Polymere, wie beispielsweise PVK (Polyvinylcarbazol) oder Derivate davon.

Die Polymere POLY3 können Homopolymere sein, d. h. sie enthalten dann nur eine einzelne Monomerstruktur, sind aber im Allgemeinen Copolymere. Die Copolymere können statistische, alternierende oder auch blockartige Strukturen aufweisen oder auch mehrere dieser Strukturen abwechselnd besitzen. Ebenso können die Polymere linear oder dendritisch aufgebaut sein. Durch das Verwenden mehrerer verschiedener Strukturelemente können Eigenschaften, wie z. B. Löslichkeit, Festphasenmorphologie, etc., eingestellt werden.

Die Polymere POLY3 werden durch Polymerisation von einem oder mehreren Monomeren hergestellt. Insbesondere für die Synthese konjugierter oder gekreuzt-konjugierter Polymere haben sich hier einige Typen bewährt, die zu C-C-Verknüpfungen (SUZUKI-Kupplung, YAMAMOTO-Kupplung, STILLE-Kupplung) oder zu C-N-Verknüpfungen (HARTWIG-BUCHWALD-Kupplung) führen. Wie die Polymerisation nach diesen Methoden durchgeführt werden kann und wie die Polymere vom Reaktionsmedium abgetrennt und gereinigt werden können, ist beispielsweise in WO 03/048225 und WO 04/022626 beschrieben.

Nach diesen Methoden kann auch die Synthese teilkonjugierter oder nichtkonjugierter Polymere durchgeführt werden, indem entsprechende Monomere verwendet werden, die nicht durchgängig konjugiert sind. Für teilkonjugierte oder nicht-konjugierte Polymere kommen aber auch andere Synthesemethoden in Frage, wie sie allgemein aus der Polymerchemie geläufig sind, wie beispielsweise Polykondensationen, die z. B. zu Ester- oder Amidverknüpfungen führen, oder kationische, anionische oder radikalische Polymerisationen, die beispielsweise über die Reaktion von Alkenen ablaufen und zu Polyethylen-Derivaten im weitesten Sinne führen, die die Chromophore in den Seitenketten gebunden enthalten.

Für bevorzugte Struktureinheiten gemäß Formel (1) bis (5) gilt Folgendes:

| | |
|---|---|
| X | steht für O, S oder N-$R^4$; |
| Y | steht für P oder As; |
| Z | steht für S oder Se; |
| $R^1$ bis $R^6$ | sind wie oben definiert, wobei an jeder Struktureinheit gemäß Formel (1) bis (5) mindestens einer der Substituenten $R^1$ bis $R^3$ ein aromatisches oder heteroaromatisches Ringsystem mit 1 bis 40 C-Atomen darstellt, das mit einem oder mehreren Substituenten $R^4$ substituiert oder unsubstituiert sein kann. |

Für besonders bevorzugte Strukturen gemäß Formel (1) bis (5) gilt Folgendes:

| | |
|---|---|
| X | steht für O oder N-$R^4$; ganz besonders bevorzugt steht X für O; |
| Y | steht für P; |
| Z | steht für S; |
| $R^1$ bis $R^6$ | sind wie oben definiert, wobei an jeder Struktureinheit gemäß Formel (1) bis (5) alle Substituenten $R^1$ bis $R^3$ ein aromatisches oder heteroaromatisches Ringsystem mit 1 bis 40 C-Atomen darstellen, die mit einem oder mehreren Substituenten $R^4$ substituiert oder unsubstituiert sein können. |

Ganz besonders bevorzugt enthalten die Substituenten $R^1$ bis $R^3$ aromatische oder heteroaromatische Ringsysteme, bei denen mindestens eine Biphenyl-artige Struktur direkt an die Einheiten gemäß Formel (1) bis (5) gebunden ist, wobei als solche Strukturen auch beispielsweise Fluorene oder Spirobifluorene zählen sollen.

Als bevorzugte Struktureinheiten gemäß Formel (1) bis (5) haben sich solche erwiesen, deren Reste $R^1$ bis $R^3$ nicht planar aufgebaut sind. Dies ist insbesondere dann der Fall, wenn mindestens einer der Substituenten $R^1$ bis $R^3$ ein $sp^3$-hybridisiertes Kohlenstoffatom (oder entsprechend auch Silicium, Germanium, Stickstoff, etc.) enthält, das dadurch näherungsweise tetraedrische (oder im Fall von Stickstoff pyramidale) Geometrie aufweist. Bevorzugte Struktureinheiten sind daher Einheiten gemäß Formel (1) bis Formel (5), in denen mindestens einer der Substituenten $R^1$ bis $R^3$ mindestens ein $sp^3$-hybridisiertes Kohlenstoffatom enthält.

Um eine deutlichere Abweichung von der Planarität zu erreichen, ist es bevorzugt, wenn dieses $sp^3$-hybridisierte Kohlenstoffatom ein sekundäres, tertiäres oder quartäres Kohlenstoffatom ist, besonders bevorzugt ist ein tertiäres oder quartäres Kohlenstoffatom, ganz besonders bevorzugt ist ein quartäres Kohlenstoffatom.

Unter einem sekundären, tertiären oder quartären Kohlenstoffatom wird ein Kohlenstoffatom mit zwei, drei bzw. vier Substituenten ungleich Wasserstoff verstanden.

Besonders bevorzugt sind Struktureinheiten gemäß Formel (1) bis Formel (5), die in mindestens einem der Reste $R^1$ bis $R^3$ ein 9,9'-Spirobifluorenderivat, ein 9,9-disubstituiertes Fluorenderivat, ein 6,6-und/oder 12,12-di- oder tetrasubstituiertes Indenofluorenderivat, ein Triptycenderivat (bevorzugt verknüpft über die Position 9 und/oder 10) oder ein Tetraarylmethanderivat enthalten. Ganz besonders bevorzugt sind Struktureinheiten gemäß Formel (1) bis (5), die in mindestens einem der Reste $R^1$ bis $R^3$ ein 9,9'-Spirobifluorenderivat enthalten.

Polymere enthaltend 9,9'-Spirobifluorenderivate und gleichzeitig Struktureinheiten gemäß einer oder mehreren der Formel (1) bis (5) sind neu und daher ebenfalls ein Gegenstand der vorliegenden Erfindung.

Beispiele für besonders bevorzugte Verbindungen VERB1, die Struktureinheiten gemäß den Formeln (1) bis (5) enthalten, sind substituierte oder unsubstituierte Strukturen gemäß den abgebildeten Formeln (6) bis (148), wobei die gestrichelten Einfachbindungen mögliche Verknüpfungen zur Molekülverlängerung (VERB1) bedeuten; Ph steht für eine substituierte oder unsubstituierte Phenylgruppe und Alkyl für eine geradkettige, verzweigte oder cyclische Alkylkette, die substituiert oder unsubstituiert sein kann und in der ein oder mehrere H-Atome durch Fluor ersetzt sein können. Potenzielle Substituenten $R^4$ sind wegen der besseren Übersichtlichkeit in der Regel nicht abgebildet:

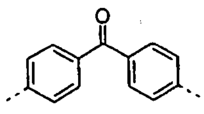
(6)

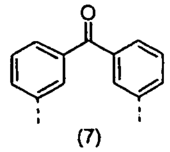
(7)

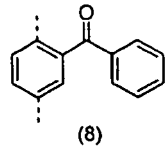
(8)

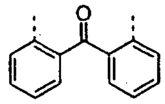
(9)

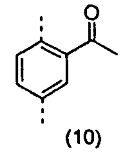
(10)

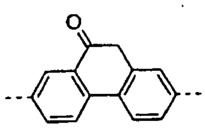
(11)

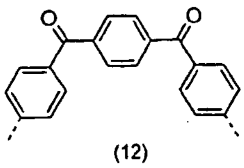
(12)

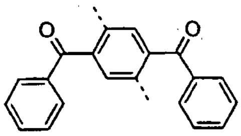
(13)

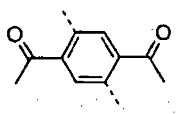
(14)

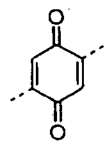
(15)

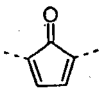
(16)

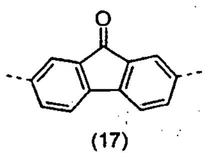
(17)

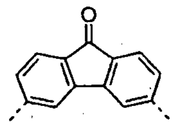
(18)

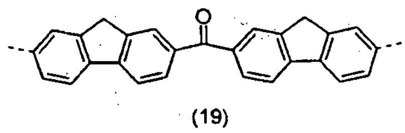
(19)

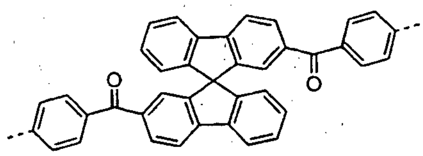
(20)

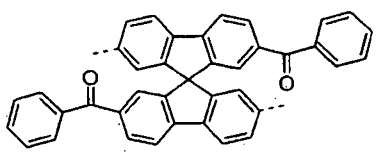
(21)

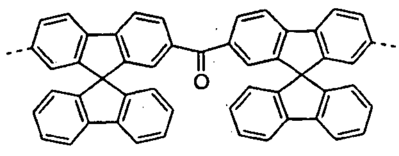
(22)

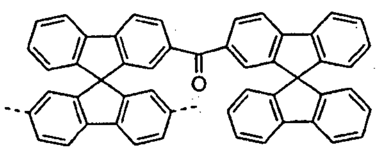
(23)

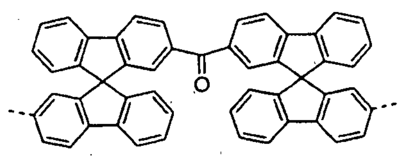
(24)

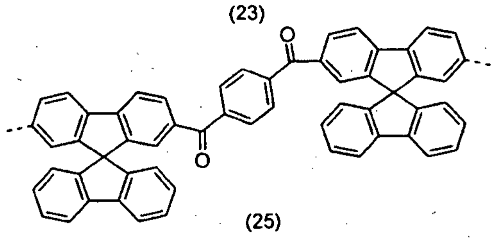
(25)

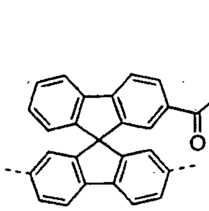
(26)

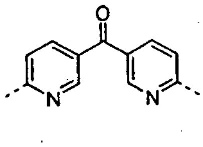
(27)

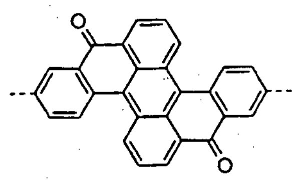
(28)

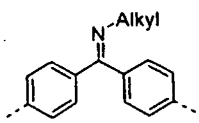
(29)

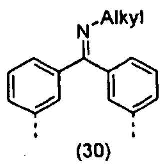
(30)

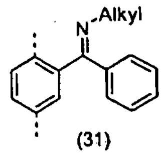
(31)

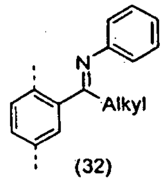
(32)

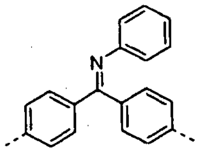
(33)

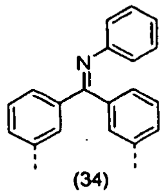
(34)

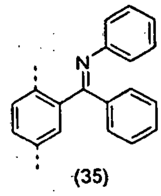
(35)

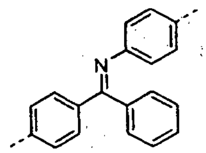
(36)

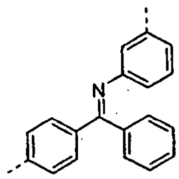
(37)

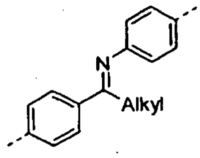
(38)

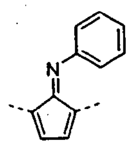
(39)

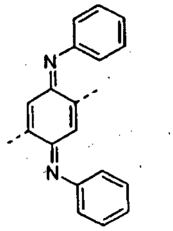
(40)

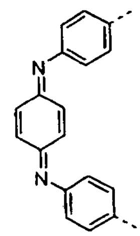

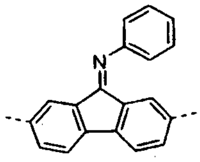
(42)

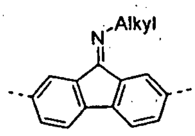
(43)

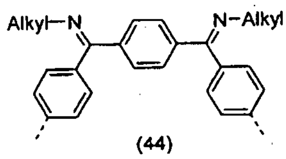
(44)

(41)

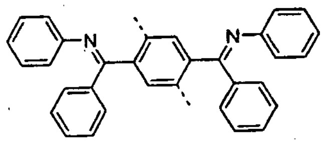

(45)

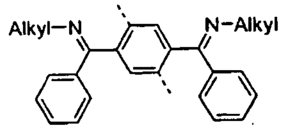

(46)

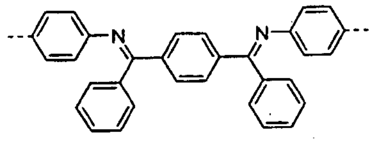

(47)

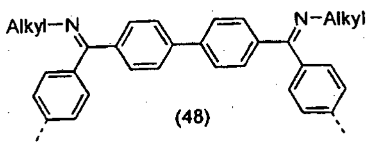

(48)

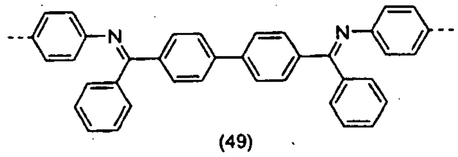

(49)

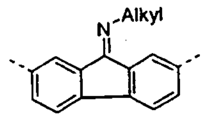

(50)

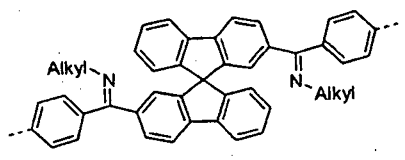

(51)

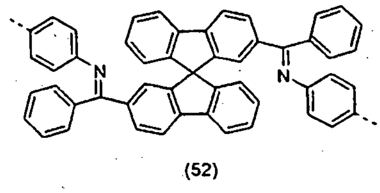

(52)

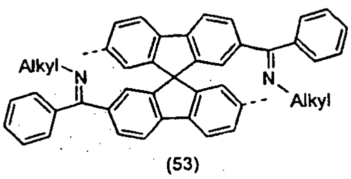

(53)

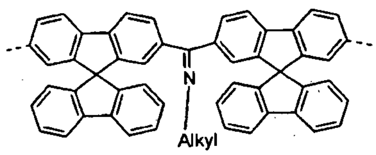

(54)

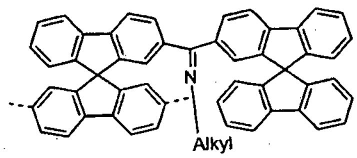

(55)

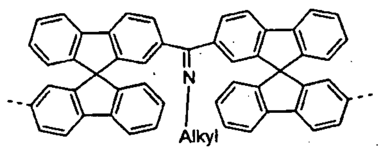

(56)

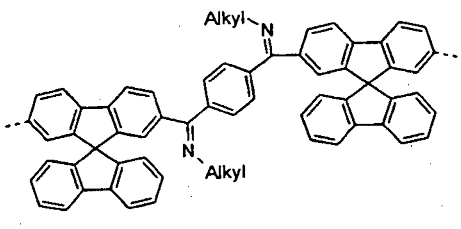

(57)

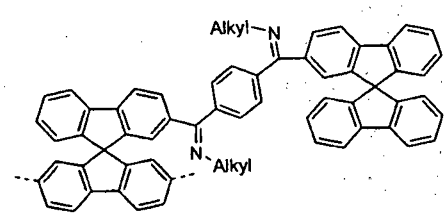

(58)

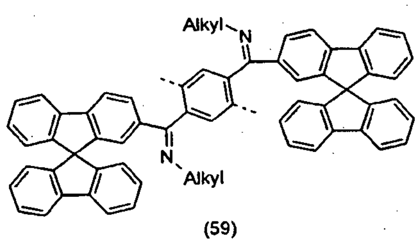
(59)

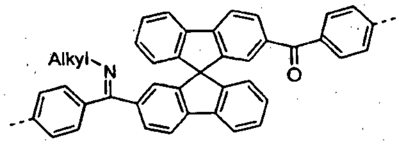
(60)

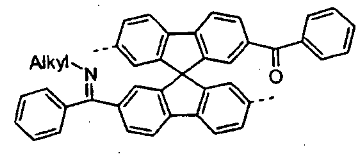
(61)

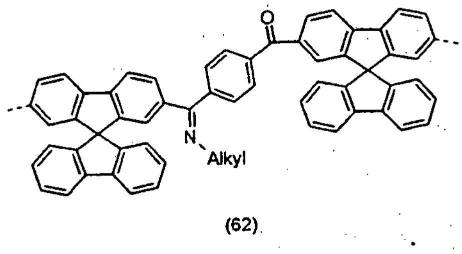
(62)

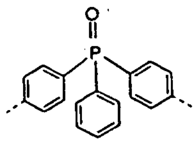
(63)

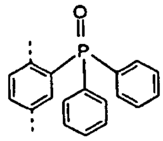
(64)

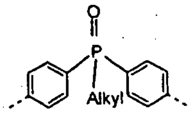
(65)

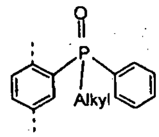
(66)

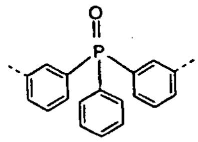
(67)

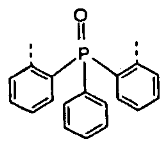
(68)

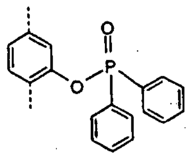
(69)

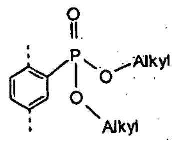
(70)

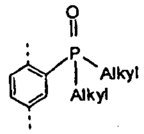
(71)

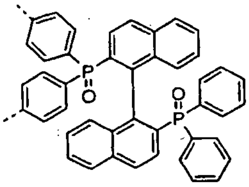
(72)

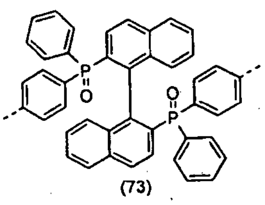
(73)

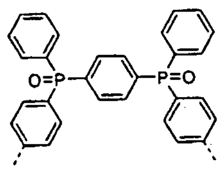
(74)

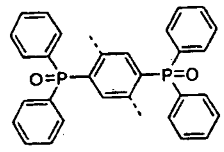
(75)

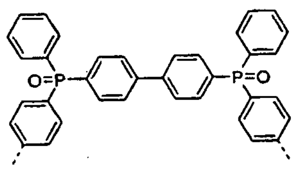
(76)

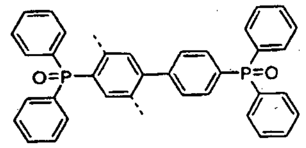
(77)

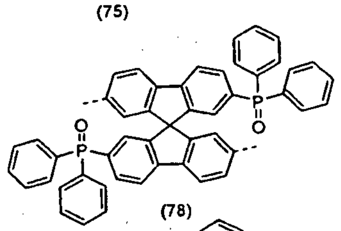
(78)

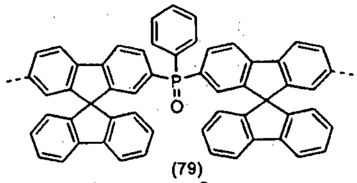
(79)

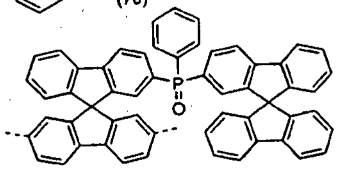
(80)

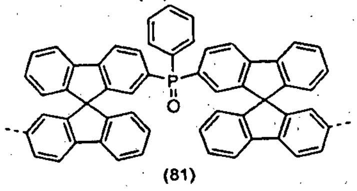
(81)

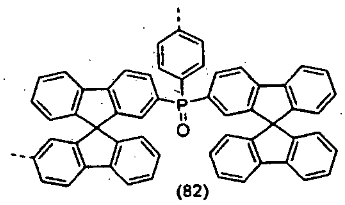
(82)

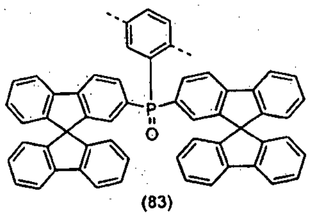
(83)

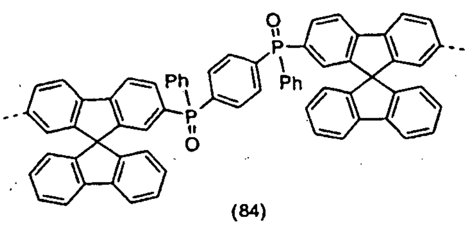
(84)

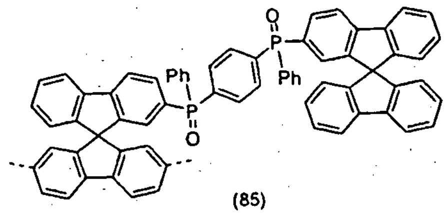
(85)

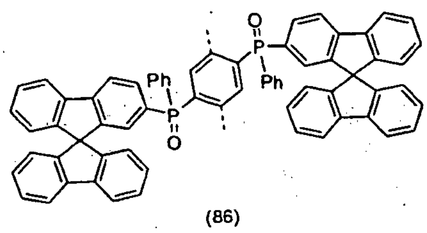
(86)

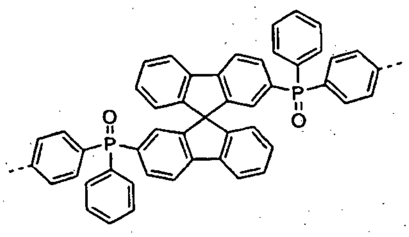
(87)

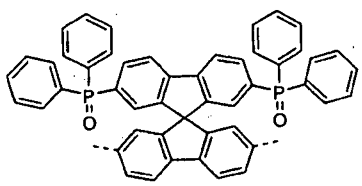

(88)

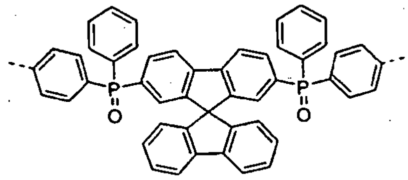

(89)

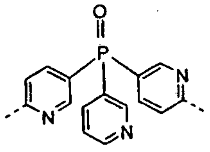

(90)

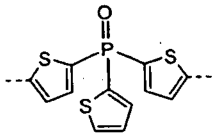

(91)

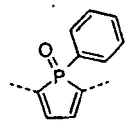

(92)

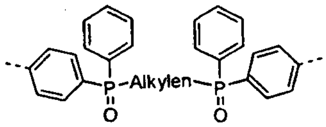

(93)

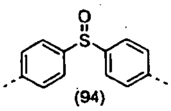

(94)

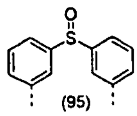

(95)

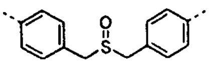

(96)

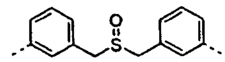

(97)

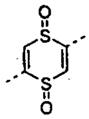

(98)

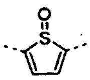

(99)

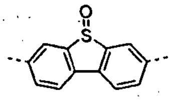

(100)

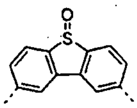

(101)

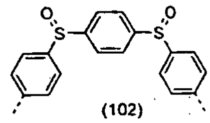

(102)

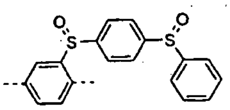

(103)

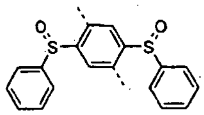

(104)

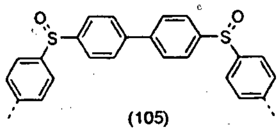

(105)

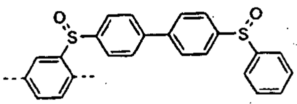

(106)

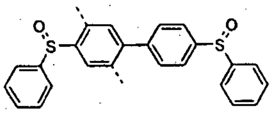

(107)

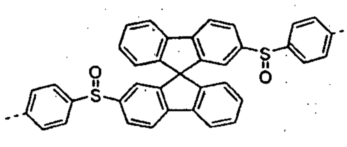

(108)

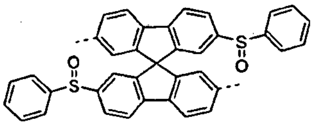
(109)

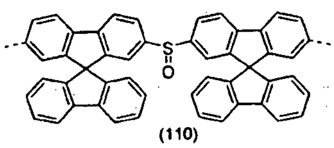
(110)

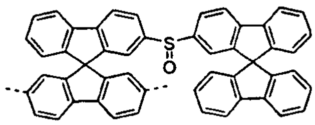
(111)

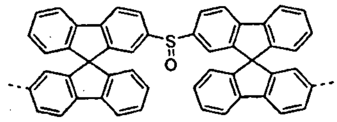
(112)

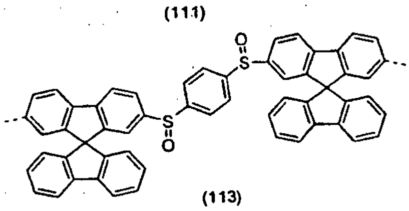
(113)

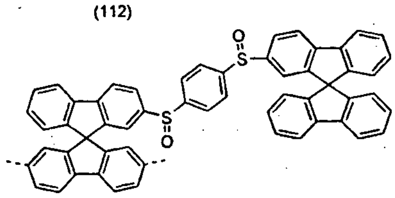
(114)

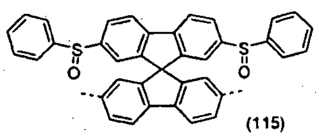
(115)

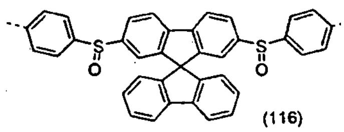
(116)

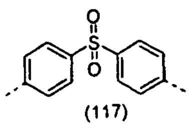
(117)

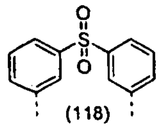
(118)

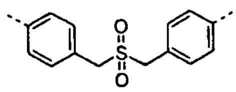
(119)

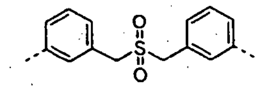
(120)

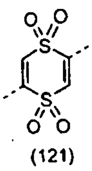
(121)

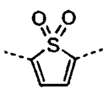
(122)

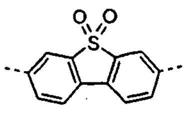
(123)

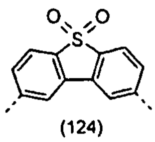
(124)

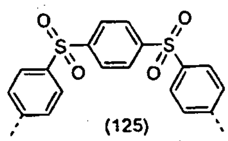
(125)

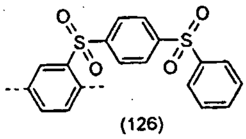
(126)

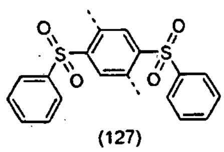
(127)

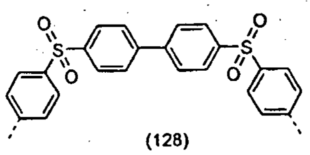
(128)

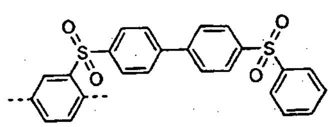
(129)

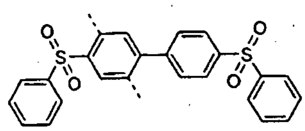
(130)

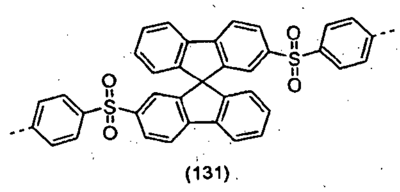
(131)

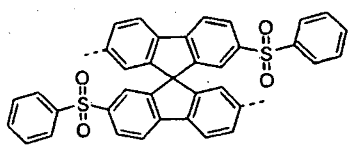
(132)

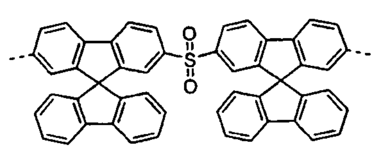
(133)

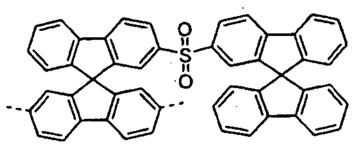

(134)

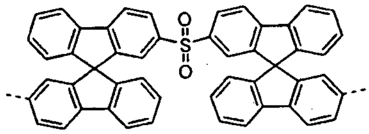

(135)

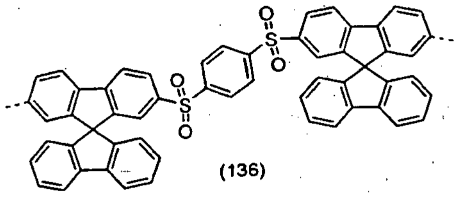

(136)

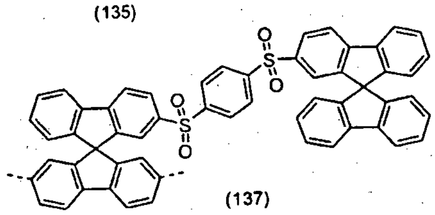

(137)

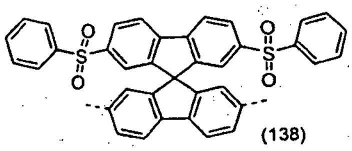

(138)

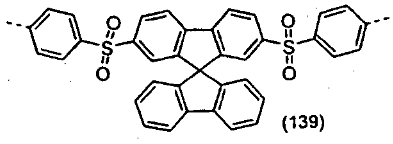

(139)

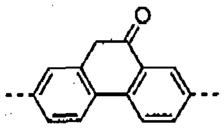

Formel (140)

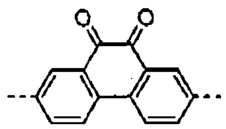

Formel (141)

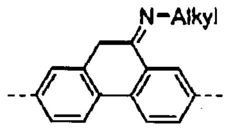

Formel (142)

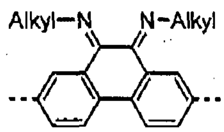

Formel (143)

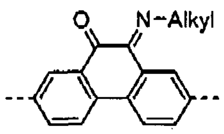

Formel (144)

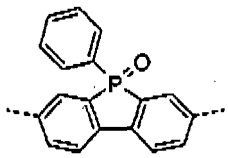

Formel (145)

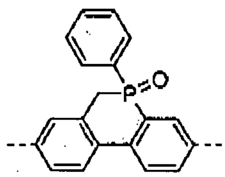

Formel (146)

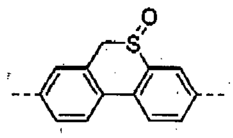

Formel (147)

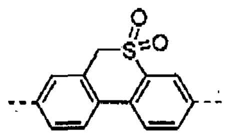

Formel (148)

Auch wenn dies aus der Beschreibung hervorgeht, sei hier nochmals explizit darauf verwiesen, dass die Struktureinheiten gemäß den Formeln (6) bis (148) auch unsymmetrisch substituiert sein können, d. h. dass an einer Einheit unterschiedliche Substituenten $R^4$ vorhanden sein können, bzw. diese auch an unterschiedliche Positionen gebunden sein können.

Verbindungen VERB1 sind Mischungs-Bestandteil der organischen Halbleiter der vorliegenden Erfindung. Es hat sich gezeigt, dass ein Anteil im Bereich von 5 - 99 Gew.% dieser Verbindungen in der Mischung hier gute Ergebnisse erzielt. Bevorzugt ist also ein Anteil von 5 - 99 Gew.%

Verbindungen VERB1. Besonders bevorzugt ist ein Anteil von 10 - 80 Gew.% VERB1, ganz besonders bevorzugt ist ein Anteil von 10 - 50 Gew.% VERB1.

Die in die organischen Halbleiter der vorliegenden Erfindung eingemischten Triplett-Emitter TRIP1 können aus beliebigen organischen, metallorganischen bzw. anorganischen Substanzklassen ausgewählt werden, die bei Raumtemperatur aus dem Triplett-Zustand Licht emittieren können, also Phosphoreszenz statt Fluoreszenz zeigen: Dies sind zunächst vor allem Verbindungen, welche Schweratome, d. h. Atome aus dem Periodensystem der Elemente mit einer

Ordnungszahl von mehr als 36, enthalten. Besonders geeignet sind hierfür Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (d. h. Ru, Os, Rh, Ir, Pd, Pt) enthalten. Besonders bevorzugt sind Triplett-Emitter auf Basis tris-ortho-metallierter Metallkomplexe.

Die Triplett-Emitter TRIP1 können niedermolekulare, oligomere, dendritische oder polymere Verbindungen sein. Da diese als Mischungsbestandteil verarbeitet werden, muss eine ausreichende Löslichkeit in geeigneten Lösungsmitteln (z. B. Toluol, Xylol, Anisol, THF, Methylanisol, Methylnaphthalin oder Mischungen dieser Lösemittel) gegeben sein, damit die Verarbeitung aus Lösung möglich ist. Als niedermolekulare Struktureinheiten kommen hier verschiedene Komplexe in Frage, welche beispielsweise in den Anmeldeschriften WO 02/068435, WO 02/081488, EP 1239526 und WO 04/026886 beschrieben sind. Als Dendrimer-Strukturen kommen für TRIP1 Komplexe in Frage, wie beispielsweise in WO 99/21935, WO 01/059030 und WO 02/066552 beschrieben.

Die erfindungsgemäße Mischung der organischen Halbleiter wird erhalten, indem dem Polymer POLY3 Verbindung VERB1, enthaltend Struktureinheiten L=X, bzw. Struktureinheiten gemäß Formel (1) bis (5), sowie ein Triplett-Emitter TRIP1 zugemischt werden.

Es kann außerdem bevorzugt sein, in die organischen Halbleiter der vorliegenden Erfindung noch weitere konjugierte, teilkonjugierte, gekreuzt-konjugierte oder nicht-konjugierte Polymere, Oligomere, Dendrimere oder weitere niedermolekulare Verbindungen einzumischen. Die Zugabe weiterer Komponenten kann sich für manche Anwendungen als sinnvoll erweisen: So kann beispielsweise durch Zugabe einer elektronisch aktiven Substanz die Loch- bzw. Elektroneninjektion, der Loch- bzw. Elektronentransport oder das

Ladungsgleichgewicht im entsprechenden Blend reguliert werden. Die Zusatzkomponente kann auch den Singulett-Triplett-Transfer erleichtern. Jedoch auch die Zugabe elektronisch inerter Verbindungen kann hilfreich sein, um beispielsweise die Viskosität einer Lösung oder die Morphologie des gebildeten Films zu kontrollieren. Die so erhaltenen Blends sind ebenfalls Gegenstand der Erfindung.

Die Darstellung der Mischung der organischen Halbleiter der vorliegenden Erfindung erfolgt folgendermaßen: Die Einzelbestandteile der Mischung werden in einem geeigneten Mischungsverhältnis zusammengegeben und in einem geeigneten Lösemittel gelöst. Geeignete Lösemittel sind beispielsweise Toluol, Anisol, Xylole, Methylanisol, Methylnaphthalin, Chlorbenzol, cyclische Ether (z. B. Dioxan, THF, Methyldioxan), Amide (z. B. NMP, DMF) oder Mischungen dieser Lösemittel. Alternativ können die Bestandteile der Mischung auch einzeln gelöst werden. Die Lösung der Mischung erhält man in diesem Fall durch Zusammenfügen der Einzellösungen im geeigneten Mischungsverhältnis. Dabei findet der Lösevorgang bevorzugt in einer inerten Atmosphäre und gegebenenfalls bei erhöhter Temperatur statt. Die Mischung wird üblicherweise nicht als Feststoff (durch nochmaliges Ausfällen) isoliert, sondern direkt aus Lösung weiter verarbeitet; jedoch sind auch Mischungen, die noch einmal ausgefällt wurden, Gegenstand der Erfindung.Ein geeignetes Verhältnis der einzelnen Komponenten ist beispielsweise eine Mischung, die insgesamt 1 - 99 mol%, bevorzugt 5 - 99 mol%, besonders bevorzugt 10 - 80 mol%, insbesondere 10 - 50 mol% Einheiten L=X, bzw. Einheiten gemäß Formel (1) bis (5) (VERB1) enthält und 0.1 - 95 mol%, bevorzugt 0.5 - 80 mol%, besonders bevorzugt 1 - 50 mol%, insbesondere 2 - 25 mol% TRIP1 enthält, wobei sich die Angaben auf die gesamt vorhandenen Einheiten Mischungsbestandteile beziehen.

Die erfindungsgemäßen organischen Halbleiter, weisen gegenüber dem o. g. Stand der Technik u. a. folgende überraschenden Vorteile auf:

- Die Löslichkeit in organischen Lösemitteln ist im Allgemeinen besser als die Löslichkeit der Polymere und Mischungen gemäß Stand der Technik. Die bessere Löslichkeit bietet einen Vorteil beispielsweise gegenüber überbrückten Carbazol-Einheiten, die als nächstliegender Stand der Technik angeführt werden, da dort häufig der maximale Carbazolanteil durch die schlechte Löslichkeit festgelegt wird, jedoch in manchen Fällen ein höherer Carbazolanteil für die weitere Verbesserung der Device-Eigenschaften wünschenswert wäre.
- Die chemische Zugänglichkeit der Einheiten gemäß Formel (1) bis (5), ist unproblematisch. Teilweise sind diese Mischungsbestandteile auch kommerziell erhältlich. Dies ist ein entscheidender Vorteil gegenüber beispielsweise den überbrückten Carbazol-Einheiten (DE 10328627.6), deren Synthese und Aufreinigung deutlich aufwändiger ist.
- Die erfindungsgemäßen Mischungen zeigen eine höhere Sauerstoffstabilität als Mischungen und Polymere gemäß Stand der Technik. Dadurch vereinfacht sich die Herstellung dieser Verbindungen und Mischungen und auch deren Verarbeitung, was einen erheblichen praktischen Vorteil darstellt.
- Die Effizienz der Lichtemission des Tripiett-Emitters ist in den erfindungsgemäßen organischen Halbleitern besser im Vergleich zu Polymeren und Mischungen gemäß dem Stand der Technik.
- Die Lebensdauer der erfindungsgemäßen Vorrichtungen ist besser als in Vorrichtungen gemäß dem Stand der Technik.

Die erfindungsgemäßen organischen Halbleiter können in PLEDs verwendet werden, insbesondere als Elektrolumineszenzmaterialien (emittierende Materialien). Für den Bau von PLEDs wird in der Regel ein allgemeines Verfahren verwendet, das entsprechend für den Einzelfall anzupassen ist. Ein solches Verfahren wurde beispielsweise in

WO 04/037887 ausführlich beschrieben.

Gegenstand der Erfindung ist daher auch die Verwendung der erfindungsgemäßen organischen Halbleiter in einer PLED als Elektrolumineszenzmaterial.

Gegenstand der Erfindung ist somit ebenfalls eine PLED mit einer oder mehreren Schichten, wobei mindestens eine dieser Schichten einen oder mehrere erfindungsgemäße organische Halbleiter.

Im vorliegenden Anmeldetext und in den folgenden Beispielen wird auf die Verwendung erfindungsgemäßer organischer Halbleiter, in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Mischungen auch für weitere Verwendungen in anderen elektronischen Devices (Vorrichtungen) zu benutzen, z. B. für organische Solarzellen (O-SCs), nicht-lineare Optik oder auch organische Laserdioden (O-Laser), um nur einige Anwendungen zu nennen. Auch diese sind Gegenstand der vorliegenden Erfindung.

Die Erfindung wird durch die nachfolgenden Beispiele näher erläutert, ohne sie dadurch einschränken zu wollen.

**Beispiele**

**Beispiel 1: Synthese der Co-Monomere für die Polymere**

Die Synthese der Co-Monomere, die für konjugierte Polymere verwendet wurden, ist in WO 02/077060 und der darin zitierten Literatur, sowie in der nicht offen gelegten Anmeldung DE 10337346.2 ausführlich beschrieben. Die im Folgenden verwendeten Monomere **M1** bis **M5** und **M8** seien hier der Übersichtlichkeit halber nochmals abgebildet:

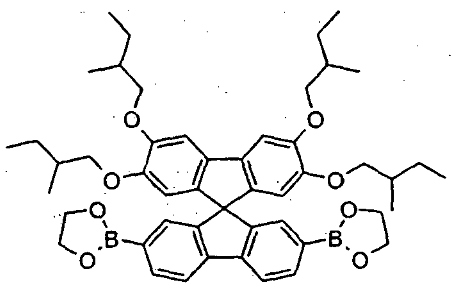

**M1**

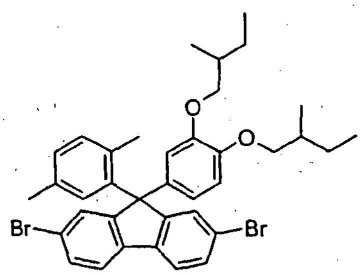

**M2**

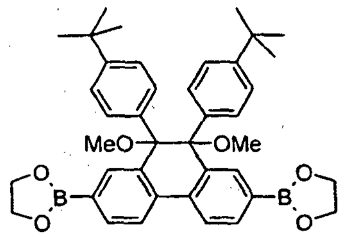

**M3**

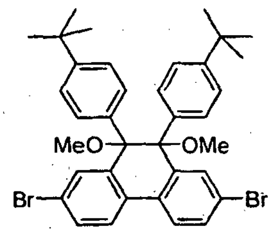

**M4**

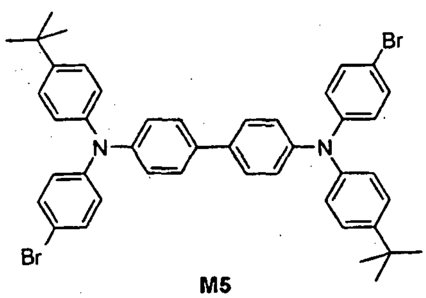

**M5**

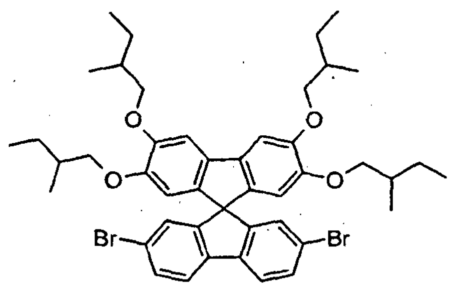

**M8**

**Beispiel 2: 4,4'-Dibrombenzophenon (Monomer M6 gemäß Formel (1))**

4,4'-Dibrombenzophenon wurde von Fluka in einer Reinheit von 98 % erhalten und durch weitere Umkristallisation aus Ethanol bis zu einer Reinheit von 99.7 % (gemäß HPLC) aufgereinigt.

**Beispiel 3: Synthese von Bis(4-bromphenyl)-phenylphosphanoxid (Monomer M7 gemäß Formel (3))**

a) Synthese von Bis(4-bromphenyl)-phenylphosphan

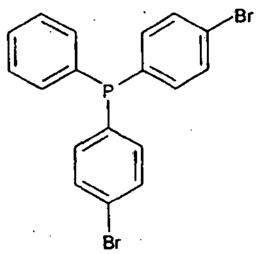

In einem trockenen 1000 mL Vierhalskolben mit Innenthermometer, Rührkern, Argon-Überlagerung und 2 Tropftrichtern wurden 33.9 g (144 mmol) Dibrombenzol in 300 mL trockenem THF gelöst und auf -70 °C gekühlt. Innerhalb 30 min. wurden 90 mL (144 mmol) n-Butyllithium (1.6 M in Hexan) zugetropft und 1 h bei dieser Temperatur nachgerührt. Dann wurden bei dieser Temperatur 12.9 g (9.75 ml, 72 mmol) Dichlorphenylphosphan in 60 mL trockenem THF zugetropft. Über Nacht ließ man auf Raumtemperatur kommen. Es wurden 20 mL Methanol zugegeben, und der Ansatz wurde zur Trockene eingedampft. Der Rückstand wurde in Dichlormethan aufgenommen, filtriert und das Lösemittel im Vakuum entfernt. Die Verbindung wurde ohne weitere Aufreinigung für die folgende Umsetzung eingesetzt.

b) Synthese von Bis(4-bromphenyl)-phenylphosphanoxid (Monomer M7)

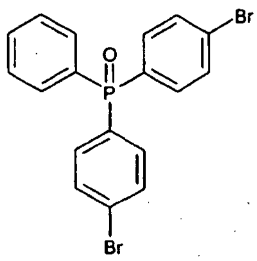

In einem 500 mL Vierhalskolben mit Innenthermometer, mechanischem Rührer, Rückflusskühler und Tropftrichter wurden 10.05 g (24 mmol) Bis(4-bromphenyl)-phenylphosphan in 200 mL Ethylacetat gelöst und auf 5 °C Innentemperatur abgekühlt. Dazu wurde innerhalb 30 min. eine Lösung von 2.25 mL (26.4 mmol) $H_2O_2$ (35 %ig) in 17.5 mL Wasser getropft und weitere 12 h bei Raumtemperatur gerührt. Anschließend wurden 25 mL gesättigte Natriumsulfit-Lösung zugegeben, die organische Phase abgetrennt, zweimal mit gesättigter Natriumsulfit-Lösung gewaschen und über Natriumsulfat getrocknet. Das Lösungsmittel wurde im Vakuum entfernt. Die Aufreinigung erfolgte zunächst durch Säulenchromatographie auf Silica mit einem Lösemittelgemisch von anfangs Hexan:Ethylacetat 2:1 zu Hexan:Ethylacetat 1:1. Weitere Reinigung erfolgte durch Umkristallisation aus Heptan/Toluol. Es wurden 6.5 g Produkt in einer Reinheit von 99.7 % (gemäß HPLC) erhalten. $^1$H-NMR (500 MHz, $CDCl_3$): [ppm] 7.46 - 7.66 (m). $^{31}$P-NMR ($CDCl_3$): [ppm] 28.40.

**Beispiel 4: Synthese von 2,7-Dibrom-9-keto-10-(2-ethylhexyl)-10-methoxy-dihydrophenanthren (Monomer M9 gemäß Formel (1))**

a) Synthese von 2,7-Dibrom-9-keto-10-(2-ethylhexyl)-10-hydroxy-dihydrophenanthren

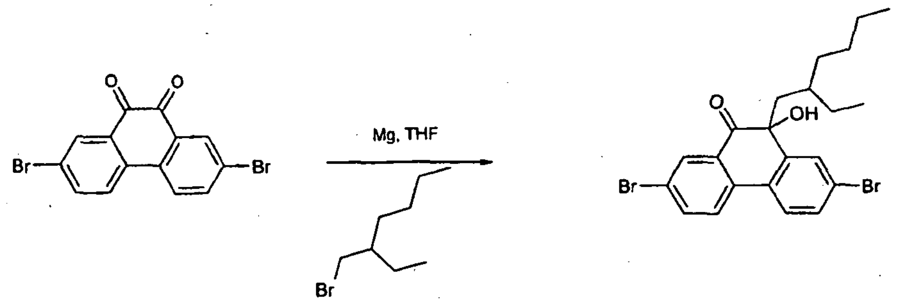


In einem 500 mL-Vierhalskolben mit Rückflusskühler, mechanischem Rührer, Innenthermometer, Argonüberlagerung und Tropftrichter wurden 4.6 g (185 mmol) Magnesium vorgelegt. Die Apparatur wurde ausgeheizt, es wurde ein Körnchen Iod zugegeben, dann wurden 37.6 mL (185 mmol) Ethylhexylbromid in 175 mL absolutem THF zugetropft. Es wurde unter Rückfluss erhitzt, bis alles Magnesium verbraucht war. Nach Abkühlen auf Raumtemperatur wurde die Grignardlösung in einen Tropftrichter überführt. In einem 1000 mL-Vierhalskolben mit mechanischem Rührer, Innenthermometer, Rückflusskühler, Tropftrichter und Argonüberlagerung wurden 45 g (123 mmol) Dibromphenanthrenchinon bei 0 °C in 300 mL THF suspendiert. Hierzu wurde die Grignardlösung so zugetropft, dass die Innentemperatur 25 °C nicht überstieg. Anschließend wurde über Nacht bei Raumtemperatur gerührt. Zum Ansatz wurden 200 mL gesättigte $NH_4Cl$-Lsg. zugegeben. Es wurde Ethylacetat zugegeben, zweimal mit gesättigter NaCl-Lsg. extrahiert, über $Na_2SO_4$ getrocknet und das Lösemittel entfernt. Der Rückstand wurde in 250 mL Hexan aufgekocht, von grünem Feststoff abfiltriert und auskristallisiert. Die Ausbeute betrug 39.3 g (67 % d. Th.). $^1H$-NMR ($CDCl_3$): [ppm] = 8.03 (m, 1H), 7.91 (m, 1H), 7.78 (m, 2H), 7.62 (m, 1 H), 7.52 (m, 1 H), 3.91 (s, mit $D_2O$ austauschbar, 1 H), 1.72 (m, 2H), 1.33 (m, 1H), 1.10 (m, 8H), 0.81 (m, 3H), 0.65 (m, 3H).

b) Synthese von 2,7-Dibrom-9-keto-10-(2-ethylhexyl)-10-methoxy-dihydrophenanthren (Monomer **M9)**

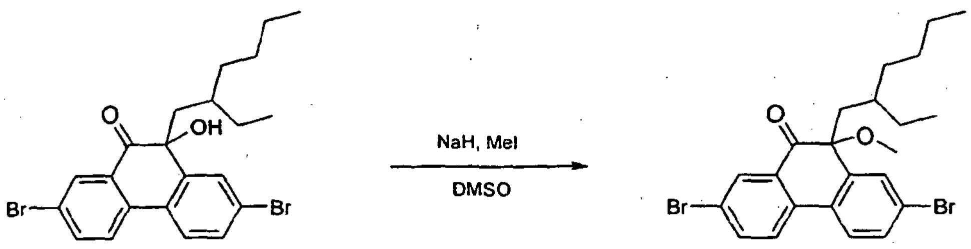


In einem ausgeheizten 500 mL-Vierhalskolben mit mechanischem Rührer, Kühler, Thermometer und Tropftrichter wurden 3.3 g (81.5 mmol) NaH (60 %ige Dispersion in Mineralöl) in 30 mL DMSO vorgelegt. Hierzu wurden 21.6 g (54.3 mmol) 2,7-Dibrom-9-keto-10-(2-ethylhexyl)-10-hydroxy-dihydrophenanthren in 60 mL DMSO langsam zugetropft, und es wurde 30 min. bei Raumtemperatur gerührt. Dann wurden unter Eiskühlung 5.1 mL (81.5 mmol) Methyliodid über 1 h zugetropft. Es wurde 2 Tage bei Raumtemperatur gerührt, dann wurde auf 5 °C abgekühlt, 90 mL halbkonz. $NH_4OH$ zugetropft, 100 mL MeOH zugetropft, 30 min im Eisbad gerührt, abgesaugt, mit MeOH gewaschen und im Vakuumtrockenschrank bei 60 °C getrocknet. Das Rohprodukt wurde aus Methanol mehrfach umkristallisiert. Die Gesamtausbeute betrug 17.3 g (65 % d. Th.) bei einer Reinheit von > 99.8%.
$^1H$-NMR ($CDCl_3$): [ppm] = 8.16 (d, $^4J_{HH}$ = 2.3 Hz, 1 H), 7.78 (m, 4H), 7.56 (dd, $^3J_{HH}$ = 8.7 Hz, $^4J_{HH}$ = 2.3 Hz, 2H), 3.17 (s, 3H), 1.71 (m, 2H), 1.26 (m, 1 H), 1.06 (m, 8H), 0.77 (m, 3H), 0.59 (m, 3H).

**Beispiel 5: Synthese von 2,7-Dibrom-9-keto-10,10-bis(4-tert-butylphenyl)-dihydrophenanthren (Monomer M10 gemäß Formel (1))**

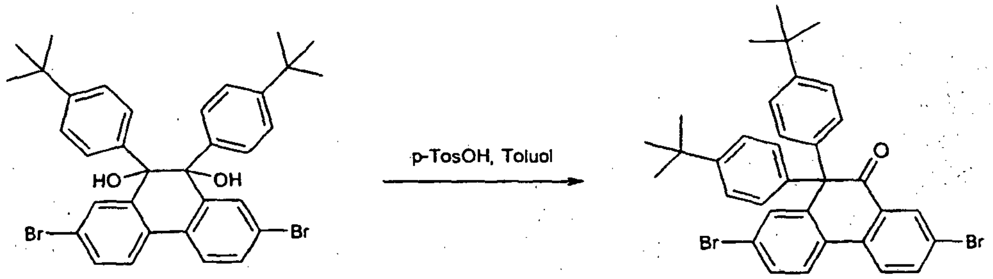


In einem 250 mL-Rundkolben mit Magnetrührer und Wasserabscheider mit Kühler wurden 200 mg para-Toluolsulfonsäure und 10 g (15.8 mmol) 2,7-Dibrom-9,10-bis(4-tert-butylphenyl)-9,10-dihydroxy-dihydrophenanthren in 80 mL Toluol suspendiert und 3 h am Wasserabscheider gekocht. Der Niederschlag wurde abgesaugt, mit Methanol gewaschen, zweimal aus Toluol umkristallisiert und unter Vakuum getrocknet. Die Ausbeute betrug 6.3 g (65 % d. Th.) bei einer Reinheit von > 99.9 %. $^1$H-NMR ($CDCl_3$): [ppm] = 8.06 (d, $^4J_{HH}$ = 2.0 Hz, 1H), 7.80 (d, $^3J_{HH}$ = 8.7 Hz, 1H), 7.73 (d, $^3J_{HH}$ = 8.7 Hz, 1H), 7.68 (dd, $^3J_{HH}$ = 8.4 Hz, $^4J_{HH}$ = 2.0 Hz, 1H), 7.55 (dd, $^3J_{HH}$ = 8.3 Hz, $^4J_{HH}$ = 2.0 Hz, 1 H), 7.26 (m, 4H), 6.91 (d, $^4J_{HH}$ = 2.0 Hz, 1 H), 6.83 (m, 4H), 1.26 (s, 18H).

**Beispiel 6: Blendbestandteile V1 und V2 (VERB1 gemäß Formel (1))**

Als Blendbestandteil **V1** wurde beispielhaft das folgende Keton verwendet, dessen Synthese bereits in DE 10317556.3 beschrieben ist:

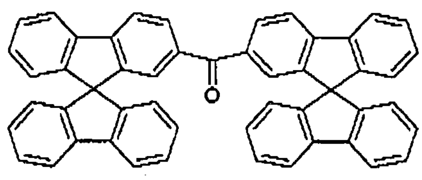

**V1**

Als Blendbestandteil V2 wurde beispielhaft das folgende Phosphinoxid verwendet, dessen Synthese in DE 10330761.3 beschrieben ist:

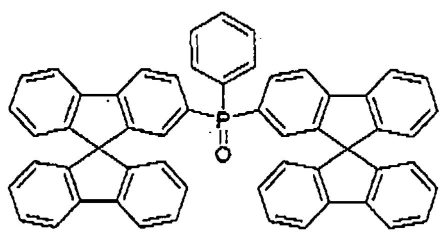

**V2**

**Beispiel 7: Triplett-Emitter TRIP1 zur Verwendung in Blends**

Bei den hier beispielhaft verwendeten Verbindungen **TRIP1** handelt es sich um Derivate von tris-(Phenylpyridyl)iridium(III). Die Synthese dieser Verbindungen ist bereits in WO 02/081488 und WO 04/026886 beschrieben. Zur Übersicht sind die hier verwendeten Iridium-Komplexe im Folgenden nochmals abgebildet:

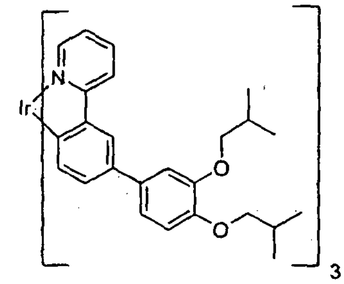

Ir1

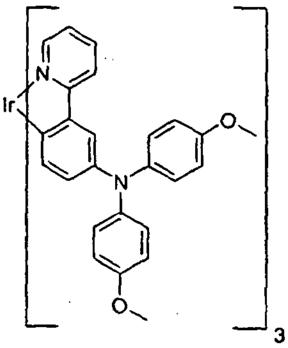

Ir2

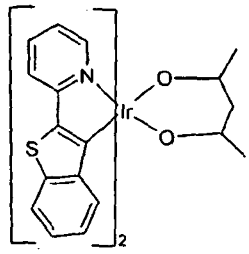

Ir3

**Beispiel 8: Weitere Blendbestandteile**

Als weitere Blendbestandteile wurden das Spiro-Triarylaminderivat **Amin1** und das Spiro-Oxadiazolderivat **Ox1** verwendet, deren Strukturen im Folgenden aufgezeigt sind:

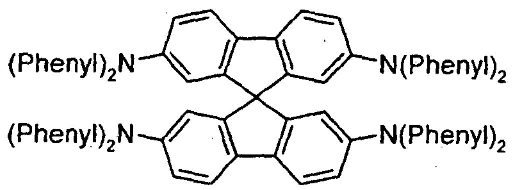

**Amin1**

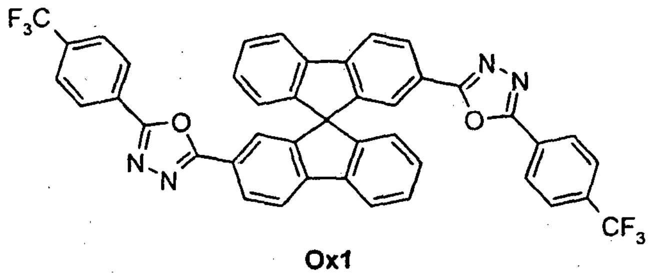

**Ox1**

**Beispiel 9: Synthese konjugierter Polymere POLY3**

Die Synthese konjugierter Polymere POLY3, die keine Einheiten gemäß Formel (1) bis (5) und keine Verbindungen TRIP2 enthalten, ist bereits beispielsweise in den Anmeldeschriften WO 02/077060, WO 03/020790 und WO 04/070772 beschrieben.

**Beispiel 10: Synthese von Polymer P1**

Die Synthese erfolgte gemäß dem in WO 03/048224 beschriebenen Verfahren. Es wurden eingesetzt: 1.6013 g (2 mmol) Monomer **M1,** 0.8118 g (1.2 mmol) Monomer **M2,** 0.3035 g (0.4 mmol) Monomer **M5,** 0.1744 g (0.4 mmol) Monomer **M7** und 2.03 g (2.2 Äquivalente) Kaliumphosphat Hydrat in 19 mL Dioxan, 6 mL Toluol und 12 mL $H_2O$. Als Katalysator wurden verwendet: 0.45 mg $Pd(OAc)_2$ und 3.65 mg $P(o\text{-}tolyl)_3$. Nach Aufarbeitung wurden 1.57 g Polymer erhalten, das ein Molekulargewicht $M_n$ 58000 g/mol und $M_w$ 185000 g/mol aufwies (GPC in THF mit Polystyrol-Standard).

**Beispiel 11: Synthese von Polymer P2**

Die Synthese erfolgte gemäß dem in WO 03/048224 beschriebenen Verfahren. Es wurden eingesetzt: 1.2889 g (2 mmol) Monomer **M3,** 0.7951 g (1.2 mmol) Monomer **M4,** 0.3035 g (0.4 mmol) Monomer **M5,** 0.1360 g (0.4 mmol) Monomer **M6** und 2.03 g (2.2 Äquivalente) Kaliumphosphat Hydrat in 19 mL Dioxan, 6 mL Toluol und 12 mL $H_2O$. Als Katalysator wurden verwendet: 0.45 mg $Pd(OAc)_2$ und 3.65 mg $P(o\text{-}tolyl)_3$. Nach Aufarbeitung wurden 1.72 g Polymer

erhalten, das ein Molekulargewicht $M_n$ 87000 g/mol und $M_w$ 219000 g/mol aufwies (GPC in THF mit Polystyrol-Standard).

**Beispiel 12: Nicht-konjugierte Polymere (POLY1) P6 und P7**

Polystryrol **P6** mit dem Schmelzindex 7.5 wurde kommerziell von Aldrich bezogen.
Die Synthese von Poly(vinylbenzophenon) **P7** erfolgte gemäß Helv. Chim. Acta 1999, 82, 338-346.

**Beispiel 13: Herstellung der Blends**

Die Herstellung der Mischungen erfolgte durch Lösen der Blendbestandteile im gewünschten Verhältnis und in der gewünschten Konzentration in Toluol. Dabei wurde der Lösevorgang in einer inerten Atmosphäre bei 60 °C durchgeführt. Die Lösung wurde ohne Isolierung der Mischung (nochmaliges Ausfällen der Feststoffanteile) direkt verarbeitet.

**Beispiel 14: Herstellung der polymeren Leuchtdioden (PLEDs)**

Wie PLEDs dargestellt werden können, ist beispielsweise in WO 04/037887 und der darin zitierten Literatur ausführlich beschrieben. Dabei hat sich gezeigt, dass die erfindungsgemäßen Blends homogenere Filme bilden als die Polymere und Blends gemäß Stand der Technik. Ohne an eine bestimmte Theorie gebunden sein zu wollen, vermuten wir, dass dies durch die bessere Löslichkeit dieser Verbindungen begründet ist.

**Beispiel 15: Übersicht über die synthetisierten und verwendeten Polymere**

Tabelle 1 gibt eine Übersicht über die Zusammensetzung einiger der synthetisierten und in den Devices verwendeten Polymere.

Tabelle 1: Übersicht über die Zusammensetzung einiger Polymere

| Polymer | Monomere | | | |
|---|---|---|---|---|
| **P1** | 50% **M1** | 30% **M2** | 10% **M5** | 10% **M7** |
| **P2** | 50% **M1** | 30% **M8** | 10% **M5** | 10% **M7** |
| **P3** | 50% **M1** | 30% **M2** | 10% **M5** | 10% **M6** |
| **P4** | 50% **M1** | 30% **M2** | 10% **M5** | 10% **M9** |
| **P5** | 50% **M1** | 50% **M6** | | |
| **P6** | 50% **M1** | 50% **M7** | | |
| **P7** | Polystyrol | | | |

**Beispiel 16: Device-Beispiele**

Tabelle 2 gibt eine Übersicht über verschiedene Blends aus Polymeren und Triplettemittern, gegebenenfalls mit weiteren Komponenten.

Tabelle 2: Einige Deviceergebnisse mit erfindungsgemäßen Blends

| Blend | Polymer[a] | Triplettemitter[b] | Weitere Bestandteile[a] | Max. Eff. | U @ 100 $cd/m^2$ | CIE x/y[c] | Lebensdauer[d] |
|---|---|---|---|---|---|---|---|
| Blend 1 a) (*) | **P1** | 20% Ir2 | | 13.55 cd/A | | 0.62/0.38 | 1000 h |
| Blend 1 b) (*) | **P1** | 8% Ir3 | | 3.69 cd/A | 5.0 V | 0.68/0.32 | 710 h |
| Blend 2 a) (*) | **P2** | 20% Ir2 | | 10.56 cd/A | 4.4 V | 0.62/0.38 | 5900 h |
| Blend 2 b) (*) | **P2** | 8% Ir3 | | 4.13 cd/A | 4.5 V | 0.68/0.32 | 1140 h |

(fortgesetzt)

| Blend | Polymer[a] | Triplettemitter[b] | Weitere Bestandteile[a] | Max. Eff. | U @ 100 cd/$m^2$ | CIE x/y[c] | Lebensdauer[d] |
|---|---|---|---|---|---|---|---|
| Blend 3 (*) | **P3** | 8% Ir2 | | 8.79 cd/A | 5.8 V | 0.68/0.32 | 830 h |
| Blende 4 (*) | **P4** | 20% Ir2 | | 5.89 cd/A | 6.5 V | 0.62 /0.38 | 2500 h |
| Blend 5 (*) | **P5** | 8% Ir3 | | 3.08 cd/A | 5.7 V | 0.68/0.32 | 480 h |
| Blend 6 a) (*) | **P6** | 8% Ir1 | | 7.49 cd/A | 6.0 V | 0.42/0.56 | 420 h |
| Blend 6 b) (*) | **P6** | 20 % Ir1 | | 20.0 cd/A | 4.5 V | 0.40/0.58 | 2000 h |
| Blend 6 c) (*) | **P6** | 2a% Ir2 | | 6.51 cd/A | 5.7 V | 0.62 /0.38 | > 10000 h |
| Blend 7 a) | 30% **P7** | 8% Ir1 | 30% **V1**<br>20% **V2**<br>20% **Amin1** | 26.78 cd/A | 4.7 V | 0.41 /0.57 | 2800 h |
| Blend 7b) | 30% **P7** | 8% Ir1 | 30% **V1**<br>20% **Amin1**<br>20% **Ox1** | 27.40 cd/A | 4.1 V | 0.38/0.59 | n.a. |

[a] Der Anteil des Polymers bzw. der weiteren Blendbestandteile bezieht sich auf die Gesamtzusammensetzung alter Bestandteile außer dem Triplettemitter.
[b] Der Anteil des Triplettemitters ist bezogen auf die Matrix, d. h. das Polymer bzw. die Mischung des Polymers mit den anderen Bestandteilen. [c] CIE-Koordinaten: Chromatizitäts-Koordinaten der Commission Internationale de l'Eclairage von 1931.
[d] Die angegebene Lebensdauer bezieht sich auf den so genannten LT50-Wert, d. h. die Zeit, die verstreicht, bis die entsprechende PLED nur noch 50 % der Anfangshelligkeit aufweist; die Werte wurden bestimmt mit einer Anfangshelligkeit von 100
(*) Referenzbeispiel

**Patentansprüche**

**1.** Organische Halbleiter, enthaltend

(A) 0.5 - 98.9 Gew.% eines beliebigen nicht-konjugierten Polymers (POLY3),
(B) 1 - 99 Gew.% mindestens einer Verbindung (VERB1), die mindestens eine Struktureinheit L=X enthält und in der Lage ist, bei Raumtemperatur glasartige Schichten zu bilden, wobei für die verwendeten Symbole gilt:

L ist bei jedem Auftreten gleich oder verschieden $(R^1)(R^2)C$, $(R^1)P$, $(R^1)As$, $(R^1)Sb$, $(R^1)Bi$, $(R^1)(R^2)(R^3)P$, $(R^1)(R^2)(R^3)As$, $(R^1)(R^2)(R^3)Sb$, $(R^1)(R^2)(R^3)Bi$, $(R^1)(R^2)S$, $(R^1)(R^2)Se$, $(R^1)(R^2)Te$, $(R^1)(R^2)S(=O)$, $(R^1)(R^2)Se(=O)$ oder $(R^1)(R^2)Te(=O)$;
X ist bei jedem Auftreten gleich oder verschieden O, S, Se oder N-$R^4$, mit der Maßgabe, dass X nicht S oder Se ist, wenn L für S, Se oder Te steht;
$R^1$, $R^2$, $R^3$ ist bei jedem Auftreten gleich oder verschieden H, F, CN, eine geradkettige, verzweigte oder cyclische Alkyl-, Alkoxy- oder Thioalkoxygruppe mit 1 bis 40 C-Atomen, die mit $R^5$ substituiert oder auch unsubstituiert sein kann, wobei ein oder mehrere H-Atome durch F, Cl, Br, I, CN oder $NO_2$ ersetzt sein können, oder ein aromatisches oder heteroaromatisches Ringsystem mit 1 bis 40 C-Atomen, das durch einen oder mehrere Reste $R^5$ substituiert sein kann, wobei zwei oder mehrere Substituenten $R^1$, $R^2$ und/oder $R^3$ auch miteinander ein mono- oder polycyclisches, aliphatisches oder aromatisches Ringsystem bilden können; dabei dürfen nicht alle Substituenten $R^1$ bis $R^3$ an einer Struktureinheit H oder F sein; die Gruppen

$R^1$ bis $R^3$ können weiterhin gegebenenfalls Bindungen zu dem Polymer aufweisen;
$R^4$ ist bei jedem Auftreten gleich oder verschieden eine geradkettige, verzweigte oder cyclische Alkyl- oder Alkoxykette mit 1 bis 22 C-Atomen, in der ein oder mehrere nicht benachbarte C-Atome durch $-R^6C=CR^6-$, $-C\equiv C-$, $Si(R^6)_2$, $Ge(R^6)_2$, $Sn(R^6)_2$, $-NR^6-$, -O-, -S-, -CO-O-, -O-CO-O- ersetzt sein können, wobei ein oder mehrere H-Atome durch Fluor ersetzt sein können, eine Aryl-, Heteroaryl- oder Aryloxygruppe mit 1 bis 40 C-Atomen, welche durch einen oder mehrere Reste $R^6$ substituiert sein kann, oder OH oder $N(R^5)_2$;
$R^5$ ist bei jedem Auftreten gleich oder verschieden $R^4$ oder CN, $B(R^6)_2$ oder $Si(R^6)_3$;
$R^6$ ist bei jedem Auftreten gleich oder verschieden H oder ein aliphatischer oder aromatischer Kohlenwasserstoffrest mit 1 bis 20 C-Atomen;

und
(C) 0.1 - 95 Gew.% eines oder mehrerer Triplett-Emitter (TRIP1), mit der Maßgabe, dass Mischungen aus zwei Polymeren ausgenommen sind, in denen das eine Polymer kovalent gebundene Triplett-Emitter enthält und das andere ein Copolymer aus TPD-Einheiten und Diphenylsulfonether- bzw. Diphenylketonether-Einheiten ist; und weiterhin mit der Maßgabe, dass Polymere, die einerseits kovalent gebundene Triplett-Emitter und andererseits Einheiten gemäß Formel (a) enthalten, von der Erfindung ausgenommen sind:

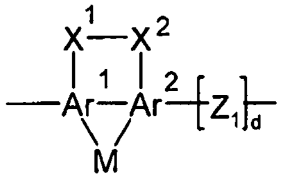

Formel (a)

worin $Ar^1$ und $Ar^2$ jeweils unabhängig eine tetravalente aromatische Kohlenwasserstoffgruppe oder eine tetravalente heterocyclische Gruppe bedeuten;

eine der Einheiten $X^1$ und $X^2$ bedeutet C(=O) oder $C(R^1)(R^2)$ und die andere bedeutet O, S, C(=O), S(=O), $SO_2$, $Si(R^3)(R^4)$, $N(R^5)$, $B(R^6)$, $P(R^7)$ oder $P(=O)(R^8)$;
wobei in der Formel (a) die Reste $R^1$, $R^2$, $R^3$, $R^4$, $R^5$, $R^6$, $R^7$ und $R^8$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten,
M bedeutet eine Gruppe, die durch Formel (b), Formel (c) oder Formel (d) dargestellt wird;

$$-Y^1-Y^2- \qquad \text{Formel (b)}$$

worin $Y^1$ und $Y^2$ jeweils unabhängig O, S, C(=O), S(=O), $SO_2$, $C(R^9)(R^{10})$, $Si(R^{11})(R^{12})$, $N(R^{13})$, $B(R^{14})$, $P(R^{15})$ oder $P(=O)(R^{16})$ bedeuten,
wobei in der Formel (b) die Reste $R^9$, $R^{10}$, $R^{11}$, $R^{12}$, $R^{13}$, $R^{14}$, $R^{15}$ und $R^{16}$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische
Gruppe, eine Arylalkenylgruppe, eine Arylethinylgruppe oder eine Cyanogruppe) bedeuten,
wobei $Y^1$ und $Y^2$ nicht identisch sind, wenn $Y^1$ nicht $C(R^9)(R^{10})$ oder $Si(R^{11})(R^{12})$ ist;

$$-Y^3-Y^4- \qquad \text{Formel (c)}$$

worin $Y^3$ und $Y^4$ jeweils unabhängig N, B, P, $C(R^{17})$ oder $Si(R^{18})$ bedeuten;
in der Formel (c) die Reste $R^{17}$ und $R^{18}$ jeweils unabhängig ein Wasserstoffatom, ein Halogenatom, eine

Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe bedeuten;

$-Y^5$ Formel (d)

worin $Y^5$ O, S, C(=O), S(=O), $SO_2$, $C(R^{19})(R^{20})$, $Si(R^{21})(R^{22})$, $N(R^{23})$, $B(R^{24})$, $P(R^{25})$ oder $P(=O)(R^{26})$ bedeutet;
wobei in de Formel (d) die Reste $R^{19}$, $R^{20}$, $R^{21}$, $R^{22}$, $R^{23}$, $R^{24}$, $R^{25}$ und $R^{26}$ jeweils unabhängig ein Wasserstoffatom, ein Halogenatom, eine Alkylgruppe, eine Alkoxygruppe, eine Alkylthiogruppe, eine Alkylaminogruppe, eine Arylgruppe, eine Aryloxygruppe, eine Arylthiogruppe, eine Arylaminogruppe, eine Arylalkylgruppe, eine Arylalkoxygruppe, eine Arylalkylthiogruppe, eine Arylalkylaminogruppe, eine Acylgruppe, eine Acyloxygruppe, eine Amidgruppe, eine Imingruppe, eine substituierte Silylgruppe, eine substituierte Silyloxygruppe, eine substituierte Silylthiogruppe, eine substituierte Silylaminogruppe, eine monovalente heterocyclische Gruppe, eine Arylalkenylgruppe, eine Arylethinylgruppe oder eine Cyanogruppe) bedeuten;
$Z_1$ bedeutet $-CR^{36}=CR^{37}-$ oder $-C{\equiv}C-$; $R^{36}$ und $R^{37}$ bedeuten jeweils unabhängig ein Wasserstoffatom, eine Alkylgruppe, eine Arylgruppe, eine monovalente heterocyclische Gruppe oder eine Cyanogruppe; d bedeutet 0 oder 1.

2. Organische Halbleiter gemäß Anspruch 1, **dadurch gekennzeichnet, dass** die Struktureinheiten L=X ausgewählt sind aus den Formeln (1) bis (5),

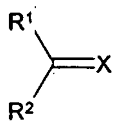
Formel (1)

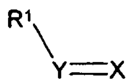
Formel (2)

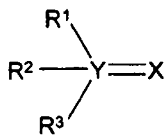
Formel (3)

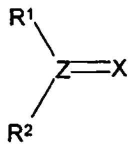
Formel (4)

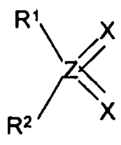
Formel (5)

wobei die verwendeten Symbole folgende Bedeutung haben:

X ist bei jedem Auftreten gleich oder verschieden O, S, Se oder N-$R^4$, mit der Maßgabe, dass X für Formel (4) und (5) nicht S oder Se sein darf;
Y ist bei jedem Auftreten gleich oder verschieden P, As, Sb oder Bi;
Z ist bei jedem Auftreten gleich oder verschieden S, Se oder Te;
$R^1$ bis $R^6$ haben dieselbe Bedeutung, wie unter Anspruch 1 beschrieben.

3. Organische Halbleiter gemäß Anspruch 1 oder 2, **dadurch gekennzeichnet, dass** die Polymere POLY3 weitere Strukturelemente enthalten.

4. Organische Halbleiter gemäß einem oder mehreren der Ansprüche 1 bis 3, **dadurch gekennzeichnet, dass** die Verbindung (VERB1), die Strukturelemente L=X, bzw. Strukturelemente gemäß Formeln (1) bis (5) enthält; die aus den Formeln (6) bis (148) ausgewählt werden,

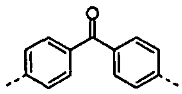
(6)

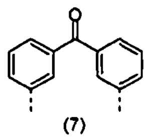
(7)

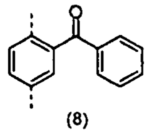
(8)

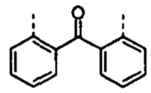
(9)

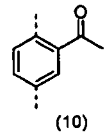
(10)

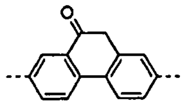
(11)

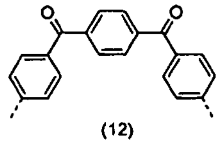
(12)

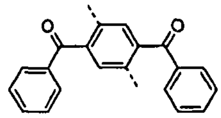
(13)

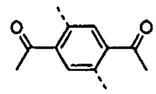
(14)

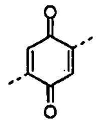
(15)

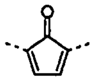
(16)

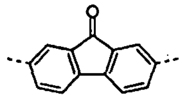
(17)

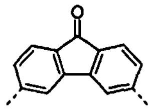
(18)

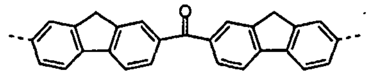
(19)

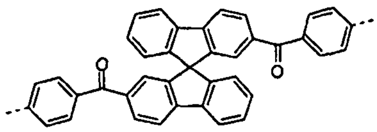
(20)

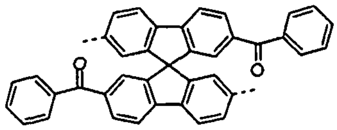
(21)

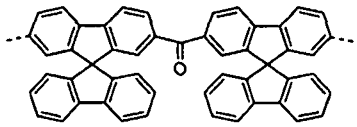
(22)

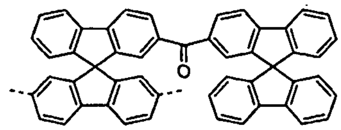
(23)

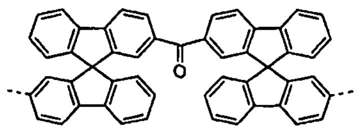
(24)

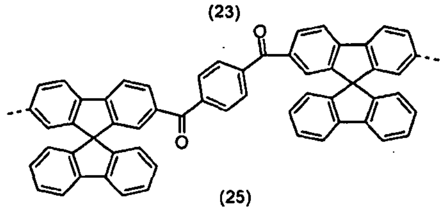
(25)

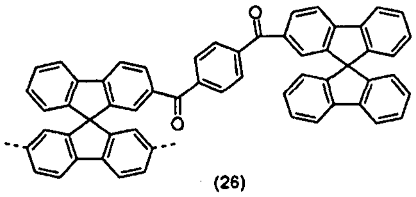
(26)

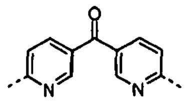
(27)

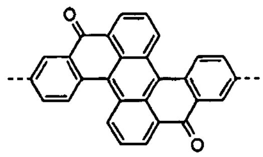
(28)

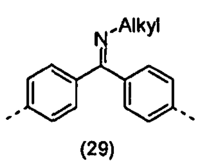
(29)

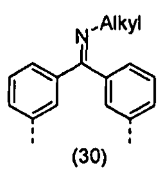
(30)

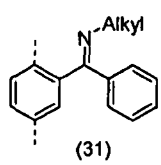
(31)

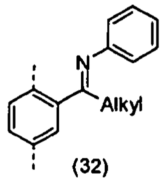
(32)

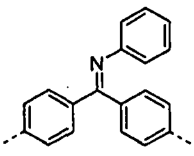
(33)

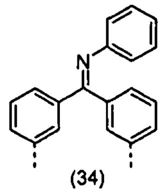
(34)

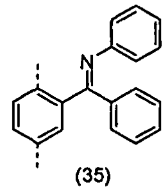
(35)

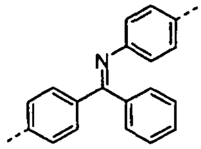
(36)

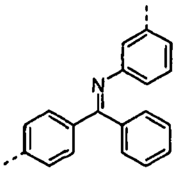
(37)

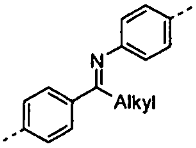
(38)

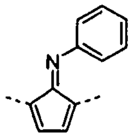
(39)

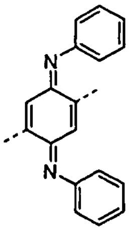
(40)

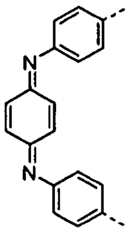
(41)

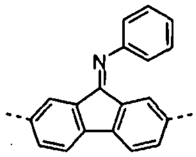
(42)

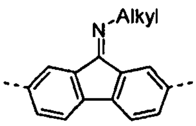
(43)

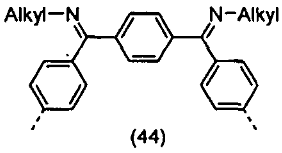
(44)

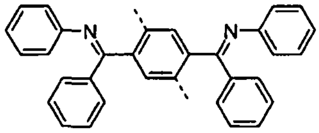
(45)

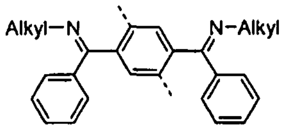
(46)

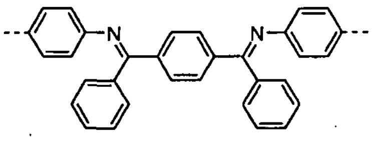
(47)

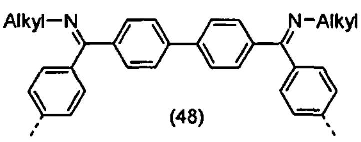
(48)

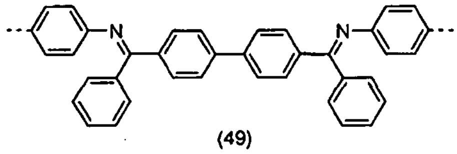
(49)

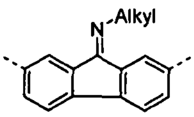
(50)

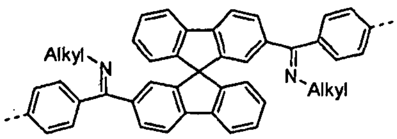
(51)

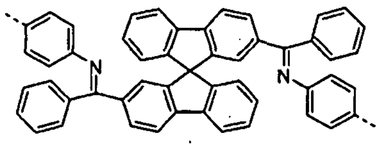
(52)

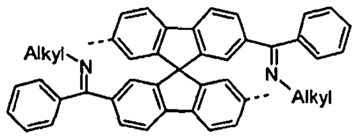
(53)

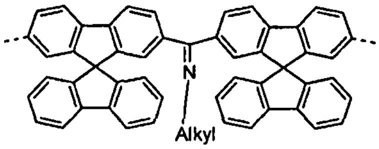
(54)

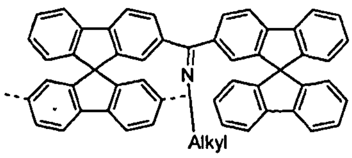

(55)

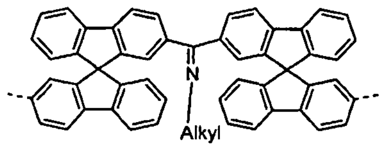

(56)

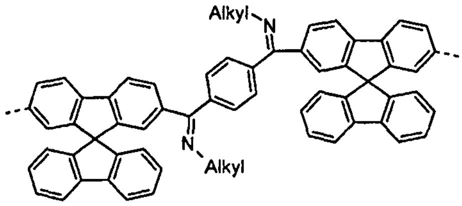

(57)

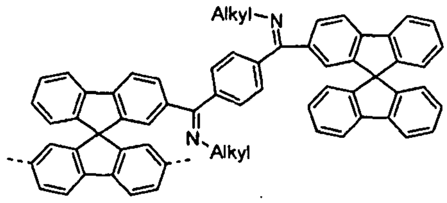

(58)

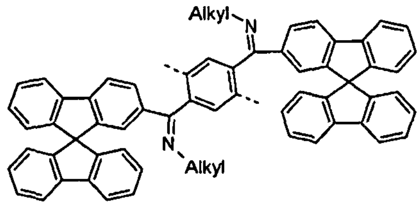

(59)

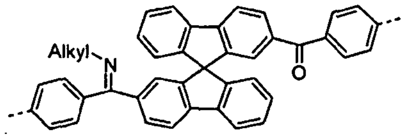

(60)

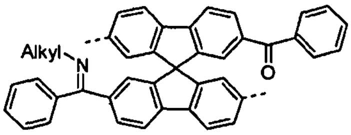

(61)

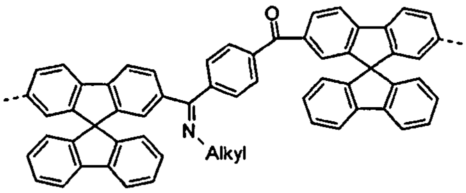

(62)

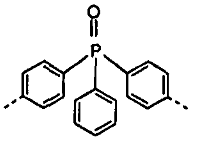
(63)

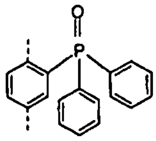
(64)

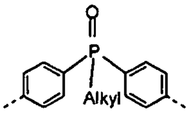
(65)

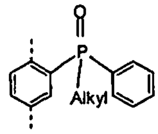
(66)

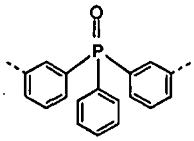
(67)

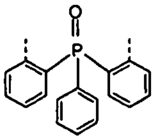
(68)

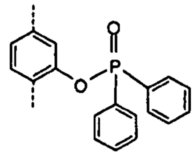
(69)

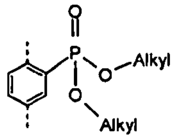
(70)

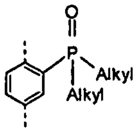
(71)

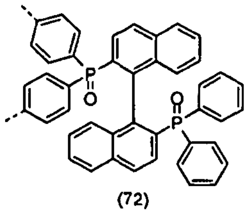
(72)

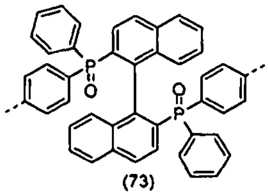
(73)

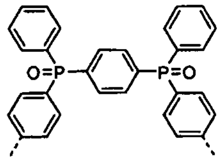
(74)

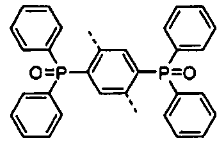
(75)

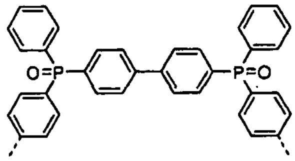
(76)

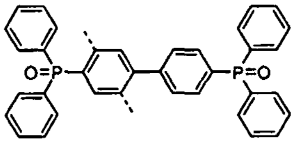
(77)

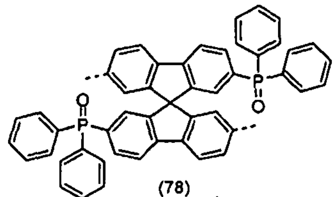
(78)

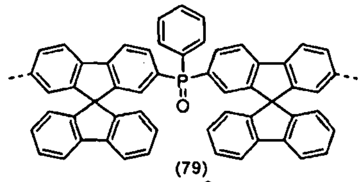
(79)

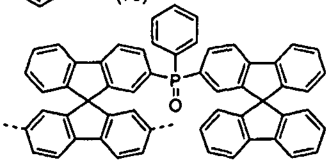
(80)

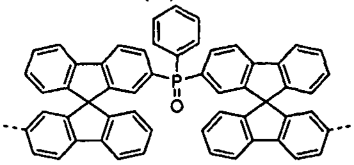
(81)

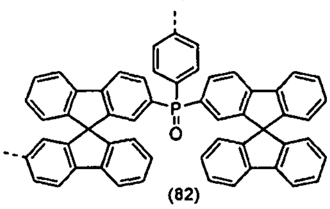
(82)

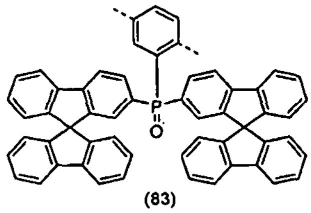
(83)

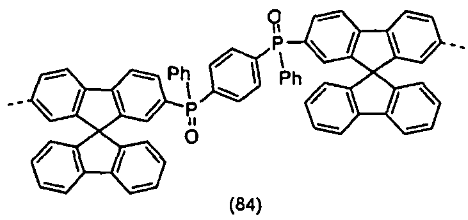
(84)

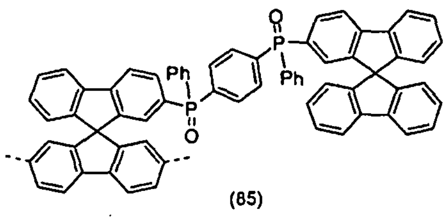
(85)

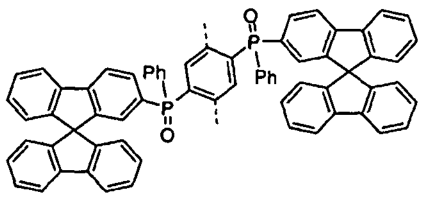

(86)

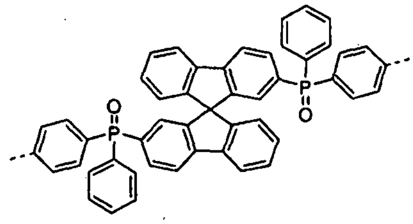

(87)

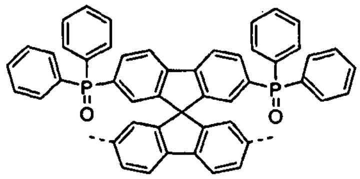

(88)

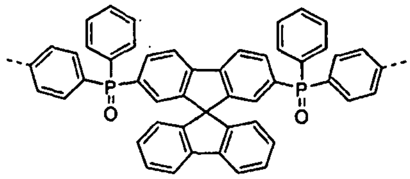

(89)

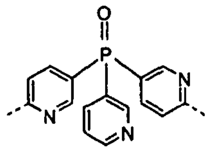

(90)

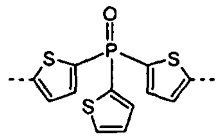

(91)

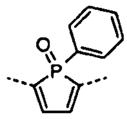

(92)

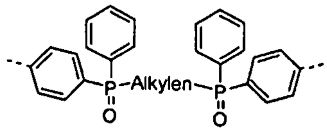

(93)

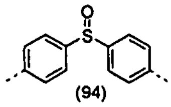
(94)
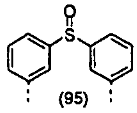
(95)
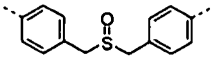
(96)
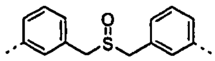
(97)

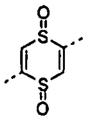
(98)
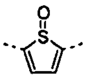
(99)
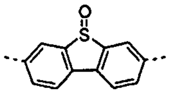
(100)
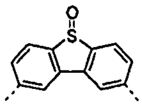
(101)
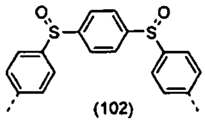
(102)

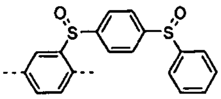
(103)
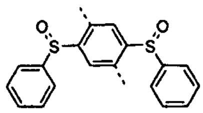
(104)
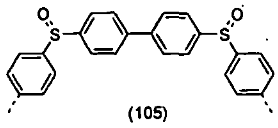
(105)

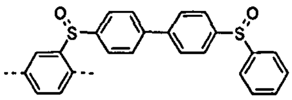
(106)
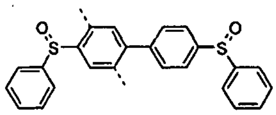
(107)
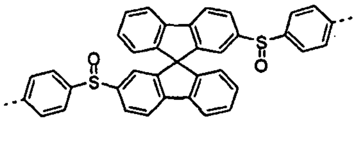
(108)

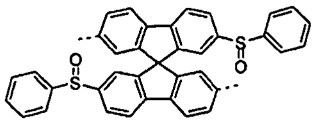
(109)
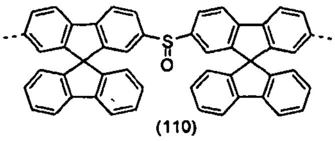
(110)

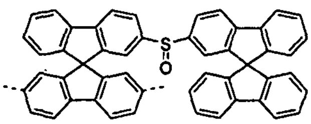
(111)
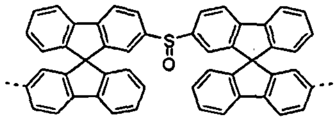
(112)

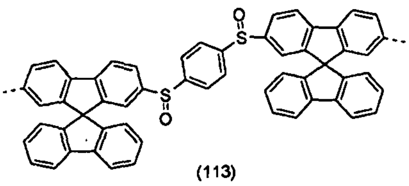
(113)
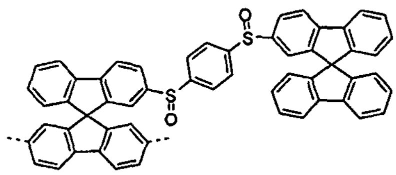
(114)

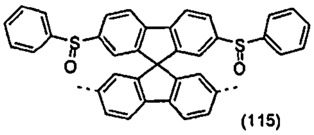
(115)
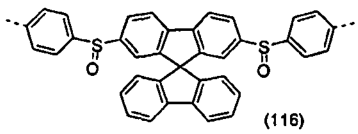
(116)

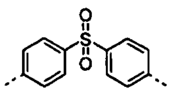
(117)
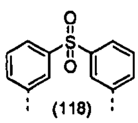
(118)
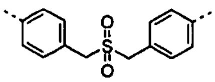
(119)
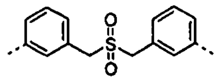
(120)

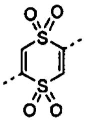
(121)
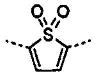
(122)
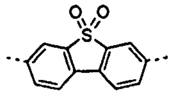
(123)
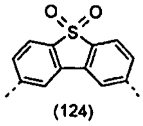
(124)
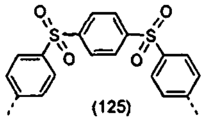
(125)

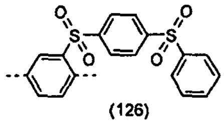
(126)
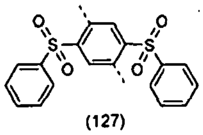
(127)
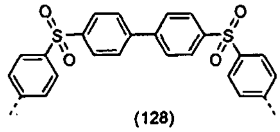
(128)

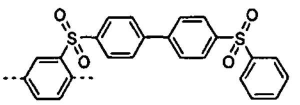

(129)

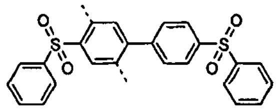

(130)

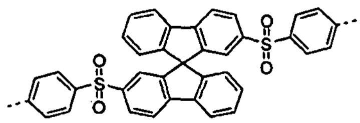

(131)

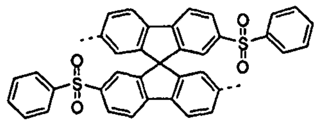

(132)

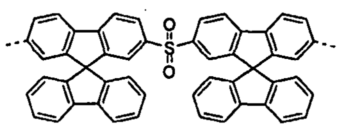

(133)

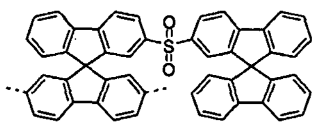

(134)

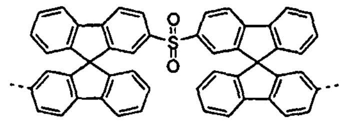

(135)

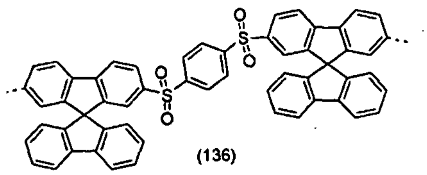

(136)

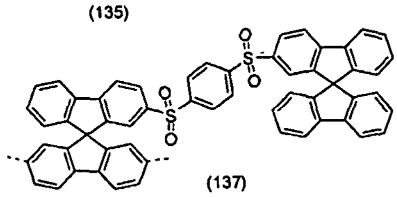

(137)

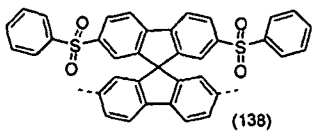

(138)

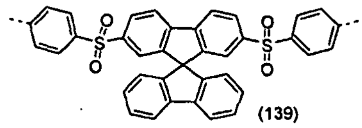

(139)

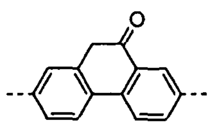

Formel (140)

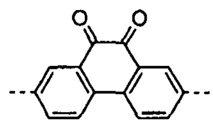

Formel (141)

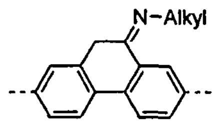

Formel (142)

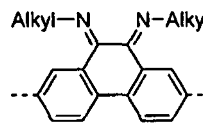

Formel (143)

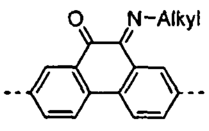

Formel (144)

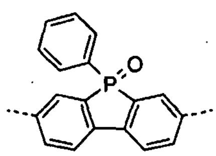

Formel (145)

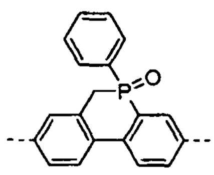

Formel (146)

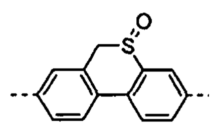

Formel (147)

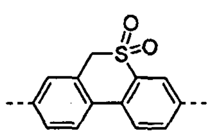

Formel (148)

die substituiert oder unsubstituiert sein können.

5. Organische Halbleiter gemäß einem oder mehreren der Ansprüche 1 bis 4, **dadurch gekennzeichnet, dass** die Polymere ausgewählt sind aus den Klassen der aromatischen Polyketone, aromatische Polyphosphinoxide oder aromatischen Polysulfone, die jeweils zur besseren Löslichkeit noch substituiert sein können, der Polycarbonsäurederivate, Hauptketten-Polyester, Seitenketten-Polyester, Poly(glycolsäuren), Poly(milchsäuren), Poly(ε-caprolactone), Polyacrylate, Poly(hydroxybenzoesäuren), Poly(alkylenterephthalate), Polycarbonsäureanhydride, Polyamide, Poly(ε-caprolactame), Polypeptide, Polyaramide, Polybenzamide, Polyimide, Poly(amid-imide), Poly(esterimide), Poly(etherimide), Polycarbonate, Poly(ester-co-carbonate), Poly(isocyanurate), Polyurethane, Polyesterpolyurethane, Poly(terephthalate), Poly(acrylate), Poly(phenylacrylate), Poly(cyanoacrylate), Poly(vinylester), Poly(vinylacetate), Seitenketten-Polyphosphinoxide, Polyetherketone (PEK), Polyethersulfone, Polysulfonamide, Polysulfonimide, Poly(vinylketone), aromatische Polyvinylketone, substituierte oder unsubstituierte Poly(vinylbenzophenone), Polystyrolanaloge Ketone, Polycarbazene, Poly-Nitrile, Poly-Isonitrile, Polystyrol, PVK (Polyvinylcarbazol) oder Derivate davon.

6. Organische Halbleiter gemäß einem oder mehreren der Ansprüche 1 bis 5, **dadurch gekennzeichnet, dass** die Triplett-Emitter Metallatome der Gruppe 8 bis 10 aus dem Periodensystem der Elemente enthalten.

7. Organische Halbleiter gemäß einem oder mehreren der Ansprüche 1 bis 6, **dadurch gekennzeichnet, dass** den organischen Halbleitern noch weitere Moleküle zugemischt werden, die niedermolekular, oligomer, dendritisch oder polymer sein können, vorzugsweise Verbindungen, die Struktureinheiten L=X, bzw. Struktureinheiten gemäß Formel (1) bis (5) enthalten.

8. Verwendung eines organischen Halbleiters gemäß einem oder mehreren der Ansprüche 1 bis 7 in organischen Leuchtdioden (PLED), organischen Solarzellen (O-SCs), organischen Laserdioden (O-Laser) oder in der nichtlinearen Optik.

9. Elektronisches Bauteil, welches eine oder mehrere aktive Schichten umfasst, wobei mindestens eine dieser aktiven Schichten einen oder mehrere organische Halbleiter gemäß einem oder mehreren der Ansprüche 1 bis 7 enthält.

10. Elektronisches Bauteil gemäß Anspruch 9, **dadurch gekennzeichnet, dass** es sich um eine organische Leuchtdiode, eine organische Solarzelle oder eine organische Laserdiode handelt.

## Claims

1. Organic semiconductors comprising

(A) 0.5 - 98.9% by weight of any desired non-conjugated polymer (POLY3),
(B) 1 - 99% by weight of at least one compound (COMP1) which contains at least one structural unit L=X and is capable of forming glass-like layers at room temperature, where the following applies to the symbols used:

L is on each occurrence, identically or differently, $(R^1)(R^2)C$, $(R^1)P$, $(R^1)As$, $(R^1)Sb$, $(R^1)Bi$, $(R^1)(R^2)(R^3)P$, $(R^1)(R^2)(R^3)As$, $(R^1)(R^2)(R^3)Sb$, $(R^1)(R^2)(R^3)Bi$, $(R^1)(R^2)S$, $(R^1)(R^2)Se$, $(R^1)(R^2)Te$, $(R^1)(R^2)S(=O)$, $(R^1)(R^2)Se(=O)$ or $(R^1)(R^2)Te(=O)$;
X is on each occurrence, identically or differently, O, S, Se or N-$R^4$, with the proviso that X is not S or Se if L stands for S, Se or Te;
$R^1$, $R^2$, $R^3$ are on each occurrence, identically or differently, H, F, CN, a straight-chain, branched or cyclic alkyl, alkoxy or thioalkoxy group having 1 to 40 C atoms, which may be substituted by $R^5$ or may also be unsubstituted, where one or more H atoms may be replaced by F, Cl, Br, I, CN or $NO_2$, or an aromatic or hetero-aromatic ring system having 1 to 40 C atoms, which may be substituted by one or more radicals $R^5$, where two or more substituents $R^1$, $R^2$ and/or $R^3$ may also form a mono- or polycyclic, aliphatic or aromatic ring system with one another; all substituents $R^1$ to $R^3$ on one structural unit here must not be H or F; the groups $R^1$ to $R^3$ may furthermore optionally have bonds to the polymer;
$R^4$ is on each occurrence, identically or differently, a straight-chain, branched or cyclic alkyl or alkoxy chain having 1 to 22 C atoms, in which one or more non-adjacent C atoms may be replaced by $-R^6C=CR^6-$, -C=C-, $Si(R^6)_2$, $Ge(R^6)_2$, $Sn(R^6)_2$, $-NR^6-$, -O-, -S-, -CO-O-, -O-CO-O-, where one or more H atoms may be replaced by fluorine, an aryl, heteroaryl or aryloxy group having 1 to 40 C atoms, which may be substituted by one or more radicals $R^6$, or OH or $N(R^5)_2$;
$R^5$ is on each occurrence, identically or differently, $R^4$ or CN, $B(R^6)_2$ or $Si(R^6)_3$;

$R^6$ is on each occurrence, identically or differently, H or an aliphatic or aromatic hydrocarbon radical having 1 to 20 C atoms;

and

(C) 0.1 - 95% by weight of one or more triplet emitters (TRIP1), with the proviso that mixtures of two polymers in which one polymer contains covalently bonded triplet emitters and the other is a copolymer comprising TPD units and diphenyl sulfone ether or diphenyl ketone ether units are excluded; and furthermore with the proviso that polymers containing on the one hand covalently bonded triplet emitters and on the other hand units of the formula (a) are excluded from the invention:

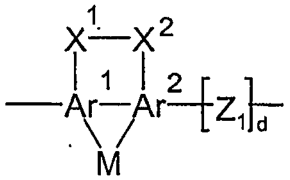

formula (a)

in which $Ar^1$ and $Ar^2$ each independently denote a tetravalent aromatic hydrocarbon group or a tetravalent heterocyclic group;

one of the units $X^1$ and $X^2$ denotes C(=O) or $C(R^1)(R^2)$ and the other denotes O, S, C(=O), S(=O), $SO_2$, $Si(R^3)(R^4)$, $N(R^5)$, $B(R^6)$, $P(R^7)$ or $P(=O)(R^8)$;

where in the formula (a) the radicals $R^1$, $R^2$, $R^3$, $R^4$, $R^5$, $R^6$, $R^7$ and $R^8$ each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;

M denotes a group which is represented by formula (b), formula (c) or formula (d),

$$-Y^1-Y^2- \qquad \text{formula (b)}$$

in which $Y^1$ and $Y^2$ each independently denote O, S, C(=O), S(=O), $SO_2$, $C(R^9)(R^{10})$, $Si(R^{11})(R^{12})$, $N(R^{13})$, $B(R^{14})$, $P(R^{15})$ or $P(=O)(R^{16})$, where in the formula (b) the radicals $R^9$, $R^{10}$, $R^{11}$, $R^{12}$, $R^{13}$, $R^{14}$, $R^{15}$ and $R^{16}$ each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;

where $Y^1$ and $Y^2$ are not identical if $Y^1$ is not $C(R^9)(R^{10})$ or $Si(R^{11})(R^{12})$;

$$-Y^3-Y^4- \qquad \text{formula (c)}$$

in which $Y^3$ and $Y^4$ each independently denote N, B, P, $C(R^{17})$ or $Si(R^{18})$;

where in the formula (c) the radicals $R^{17}$ and $R^{18}$ each independently denote a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkylthio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;

$$-Y^5- \qquad \text{formula (d)}$$

in which $Y^5$ denotes O, S, C(=O), S(=O), $SO_2$, $C(R^{19})(R^{20})$, $Si(R^{21})(R^{22})$, $N(R^{23})$, $B(R^{24})$, $P(R^{25})$ or $P(=O)(R^{26})$;

where in the formula (d) the radicals $R^{19}$, $R^{20}$, $R^{21}$, $R^{22}$, $R^{23}$, $R^{24}$, $R^{25}$ and $R^{26}$ each independently denote

a hydrogen atom, a halogen atom, an alkyl group, an alkoxy group, an alkylthio group, an alkylamino group, an aryl group, an aryloxy group, an arylthio group, an arylamino group, an arylalkyl group, an arylalkoxy group, an arylalkyl thio group, an arylalkylamino group, an acyl group, an acyloxy group, an amide group, an imine group, a substituted silyl group, a substituted silyloxy group, a substituted silylthio group, a substituted silylamino group, a monovalent heterocyclic group, an arylalkenyl group, an arylethynyl group or a cyano group;

$Z_1$ denotes $-CR^{36}=CR^{37}-$ or -C≡C-; $R^{36}$ and $R^{37}$ each independently denote a hydrogen atom, an alkyl group, an aryl group, a monovalent heterocyclic group or a cyano group; d denotes 0 or 1.

**2.** Organic semiconductors according to Claim 1, **characterised in that** the structural units L=X are selected from the formulae (1) to (5),

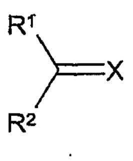
formula (1)

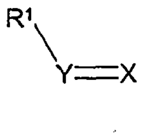
formula (2)

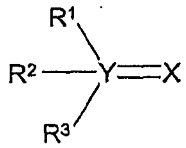
formula (3)

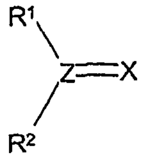
formula (4)

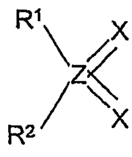
formula (5)

where the symbols used have the following meanings:

X is on each occurrence, identically or differently, O, S, Se or N-$R^4$, with the proviso that X cannot be S or Se for formulae (4) and (5);
Y is on each occurrence, identically or differently, P, As, Sb or Bi;
Z is on each occurrence, identically or differently, S, Se or Te;
$R^1$ to $R^6$ have the same meaning as described under Claim 1.

**3.** Organic semiconductors according to Claim 1 or 2, **characterised in that** the polymers POLY3 contain further structural elements.

**4.** Organic semiconductors according to one or more of Claims 1 to 3, **characterised in that** the compound (COMP1) contains structural elements L=X or structural elements of the formulae (1) to (5) selected from the formulae (6) to (148),

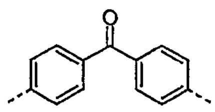
(6)

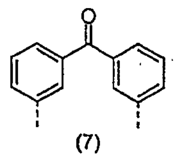
(7)

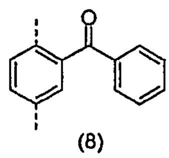
(8)

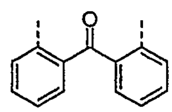
(9)

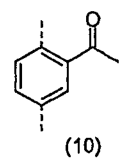
(10)

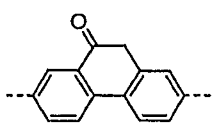
(11)

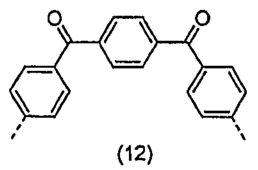
(12)

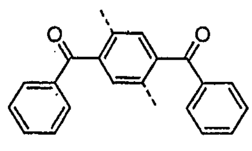
(13)

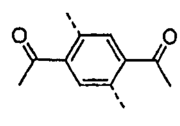
(14)

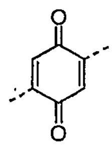
(15)

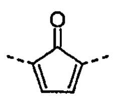
(16)

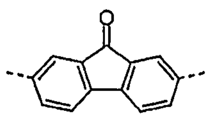
(17)

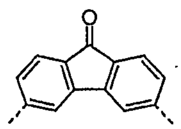
(18)

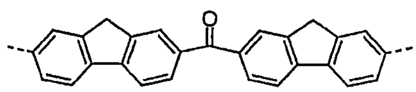
(19)

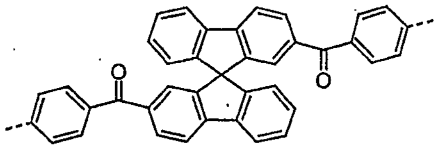
(20)

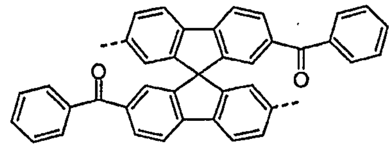
(21)

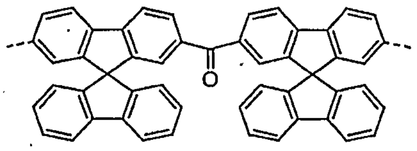
(22)

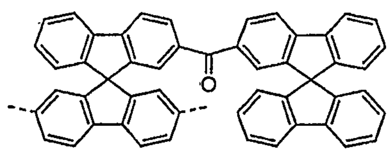
(23)

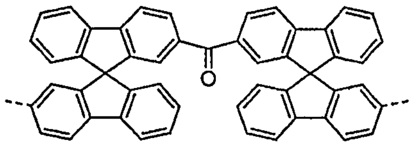
(24)

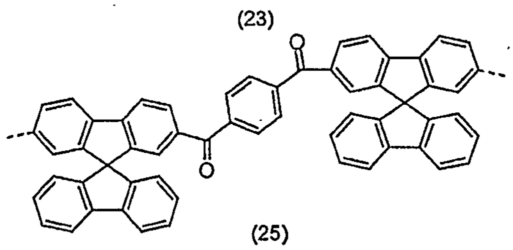
(25)

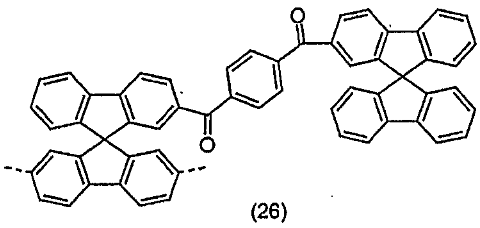
(26)

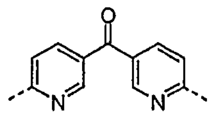
(27)

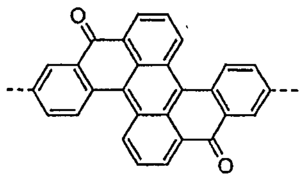
(28)

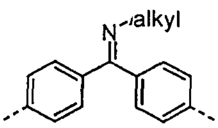
(29)

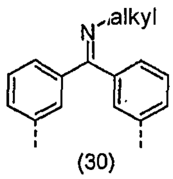
(30)

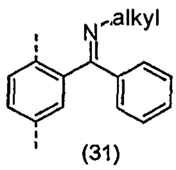
(31)

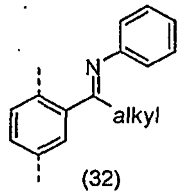
(32)

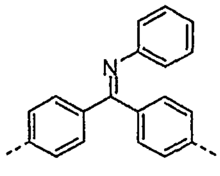

(33)

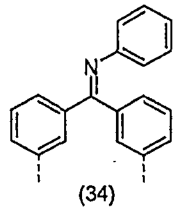

(34)

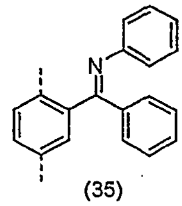

(35)

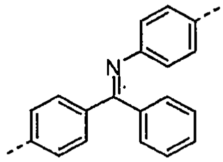

(36)

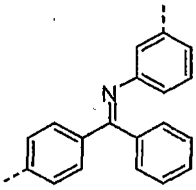

(37)

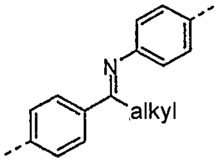

(38)

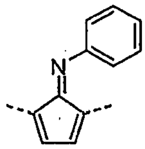

(39)

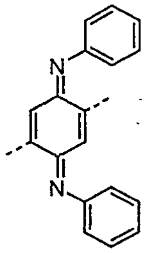

(40)

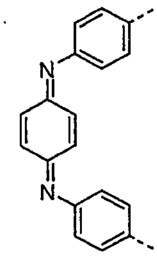

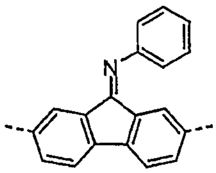

(42)

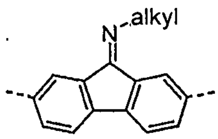

(43)

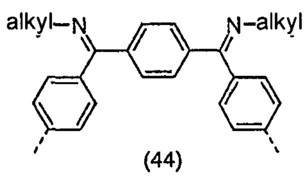

(44)

(41)

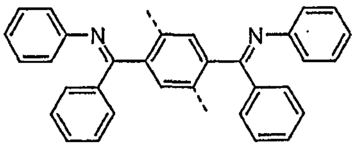

(45)

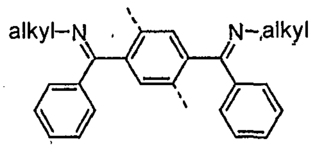

(46)

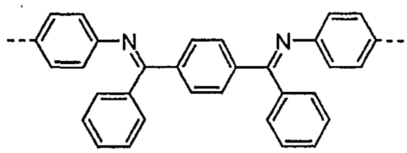

(47)

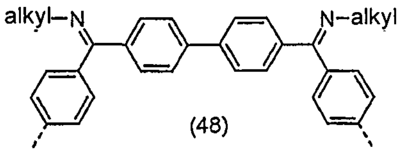

(48)

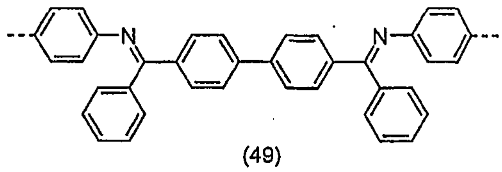

(49)

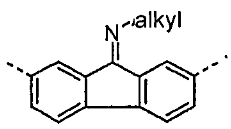

(50)

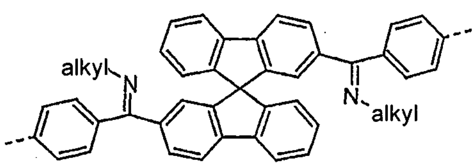

(51)

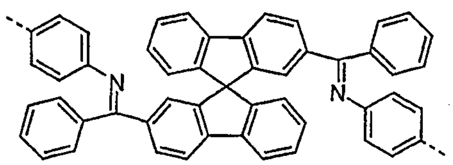

(52)

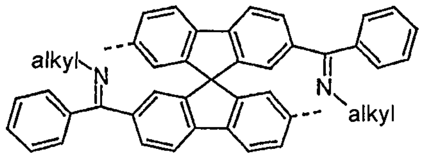

(53)

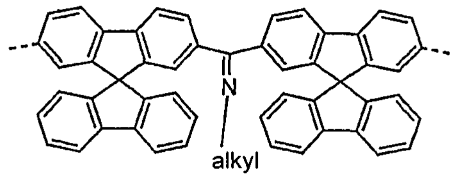

(54)

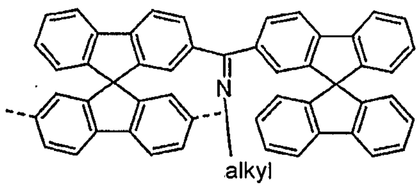

(55)

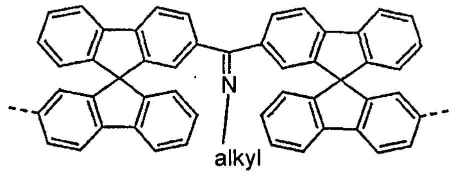

(56)

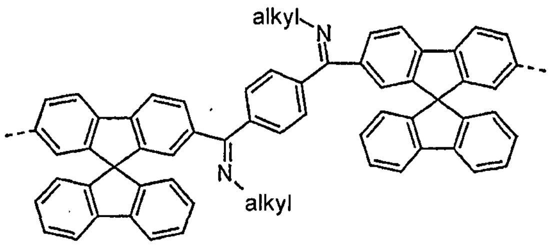

(57)

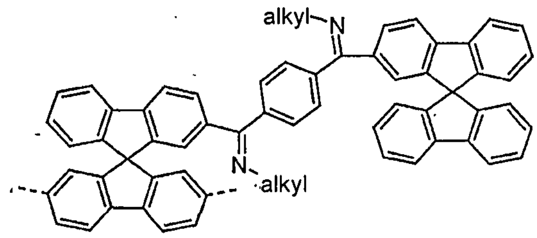

(58)

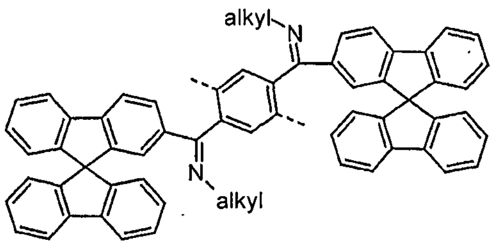

(59)

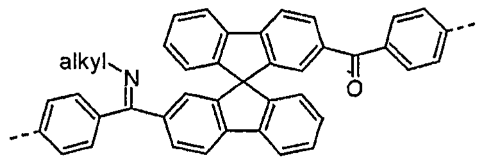

(60)

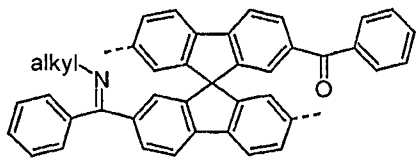

(61)

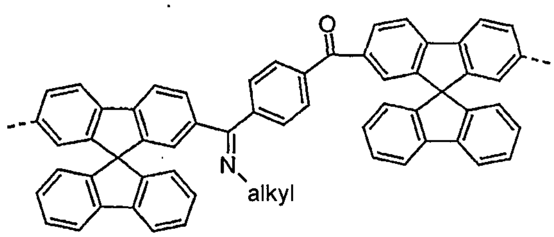

(62)

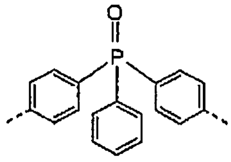
(63)

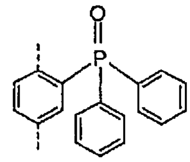
(64)

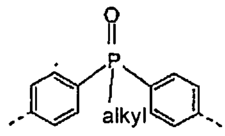
(65)

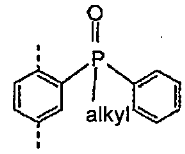
(66)

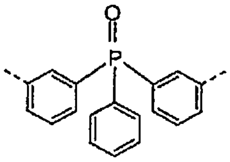
(67)

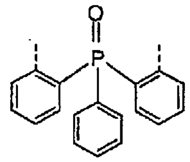
(68)

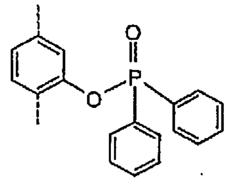
(69)

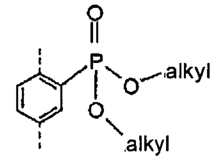
(70)

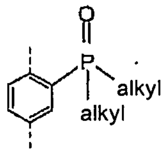
(71)

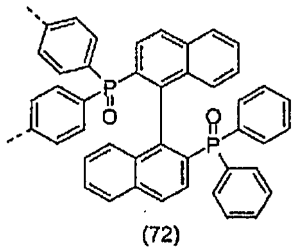
(72)

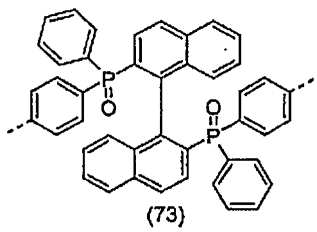
(73)

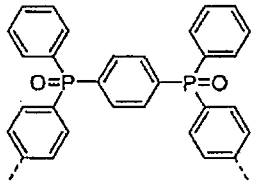
(74)

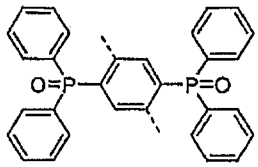
(75)

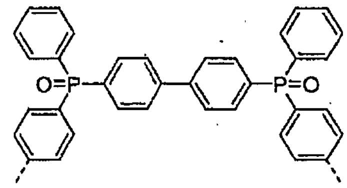
(76)

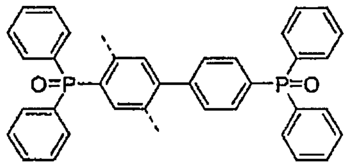
(77)

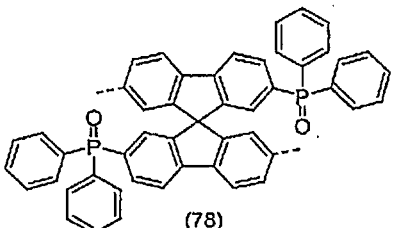
(78)

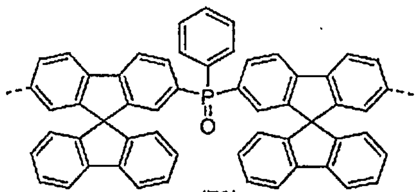
(79)

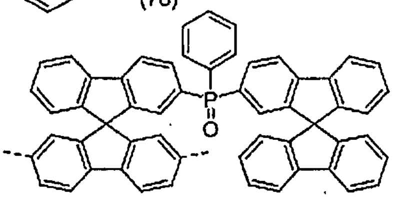
(80)

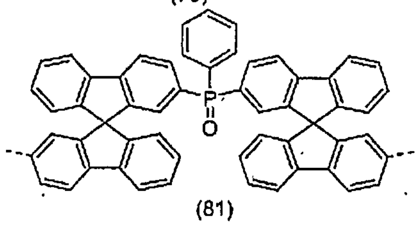
(81)

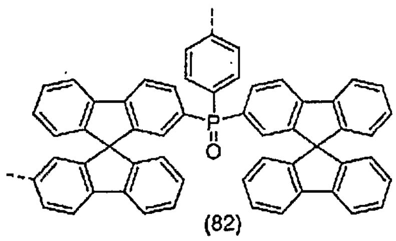
(82)

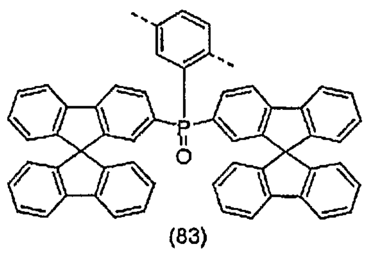
(83)

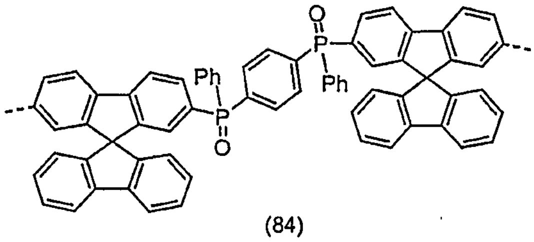

(84)

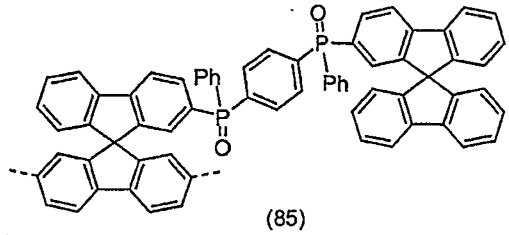

(85)

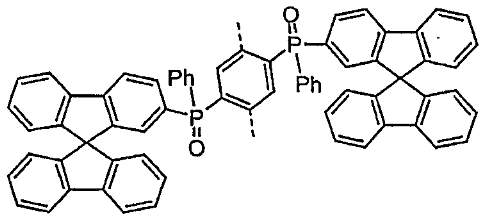

(86)

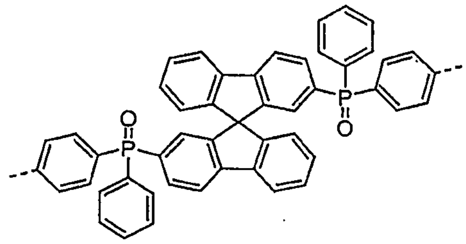

(87)

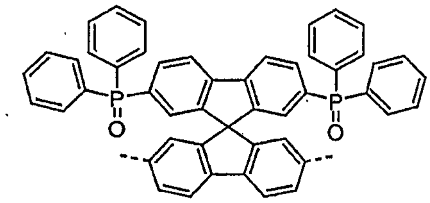

(88)

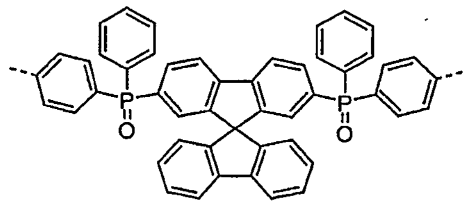

(89)

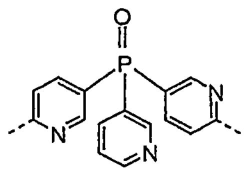

(90)

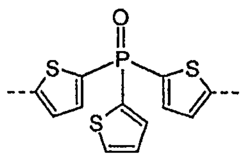

(91)

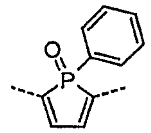

(92)

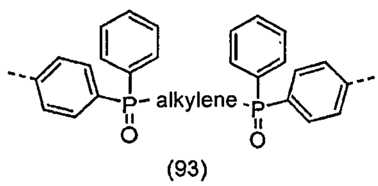

(93)

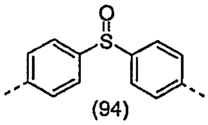
(94)

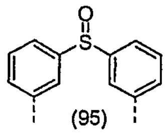
(95)

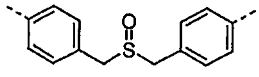
(96)

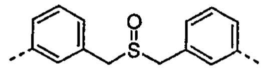
(97)

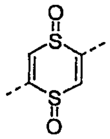
(98)

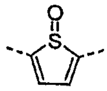
(99)

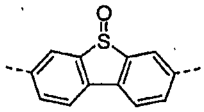
(100)

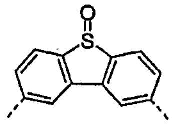
(101)

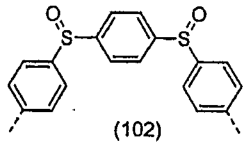
(102)

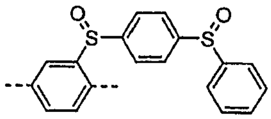
(103)

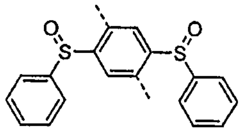
(104)

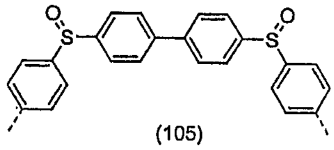
(105)

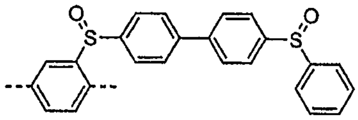
(106)

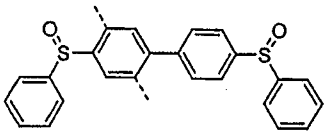
(107)

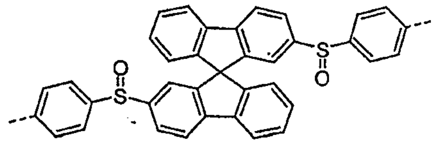
(108)

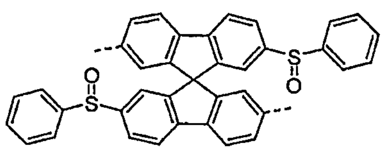
(109)

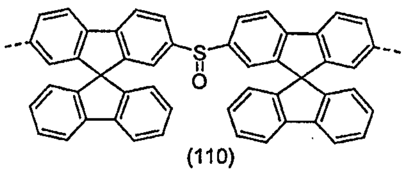
(110)

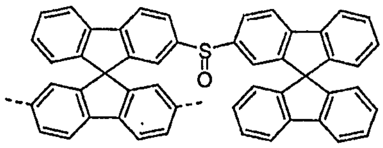
(111)

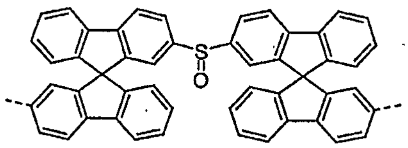
(112)

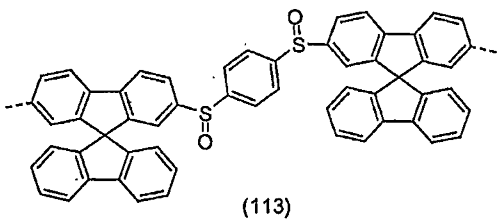
(113)

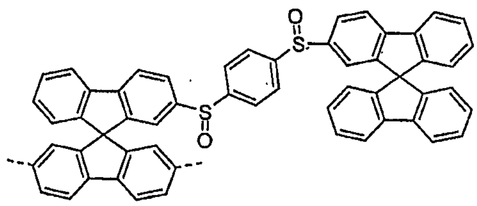
(114)

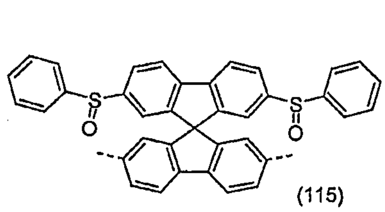
(115)

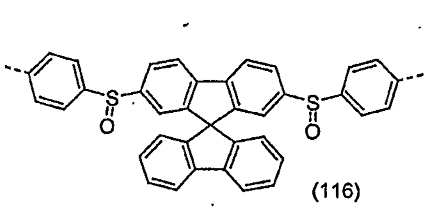
(116)

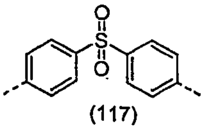
(117)

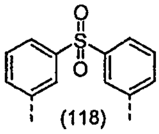
(118)

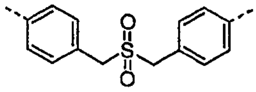
(119)

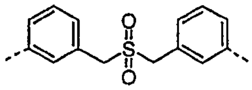
(120)

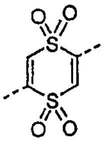
(121)

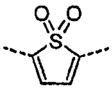
(122)

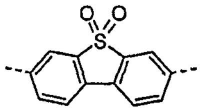
(123)

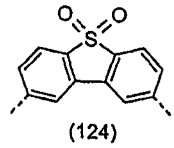
(124)

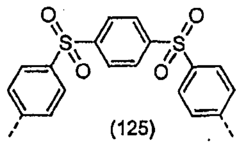
(125)

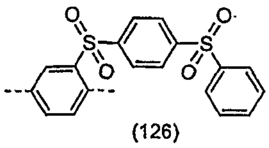
(126)

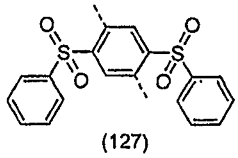
(127)

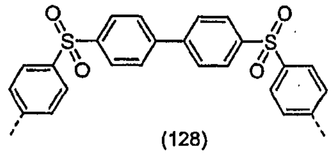
(128)

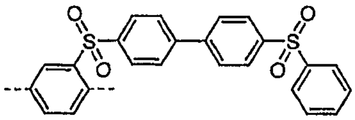
(129)

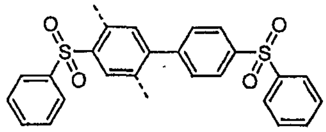
(130)

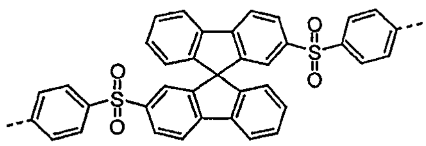
(131)

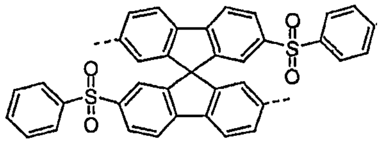
(132)

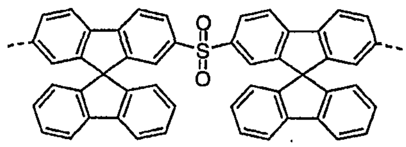
(133)

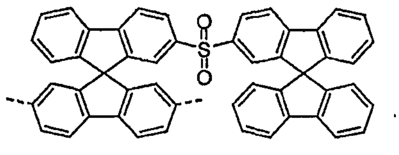
(134)

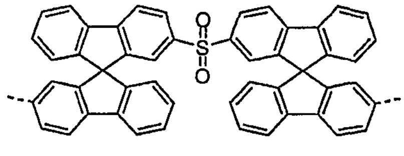
(135)

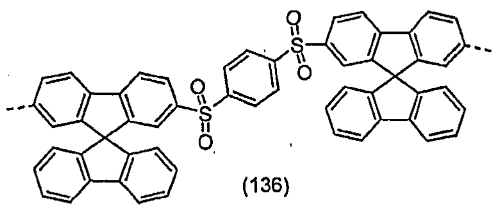
(136)

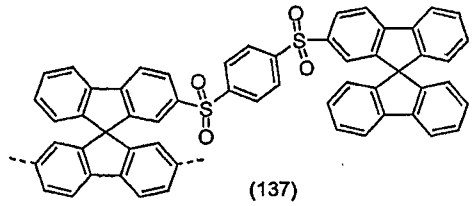
(137)

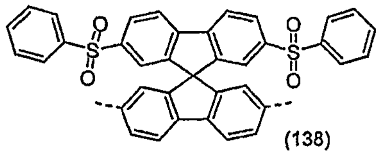
(138)

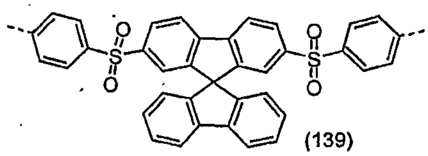
(139)

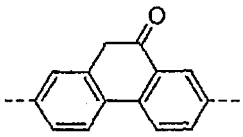

formula (140)

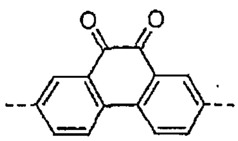

formula (141)

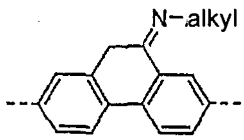

formula (142)

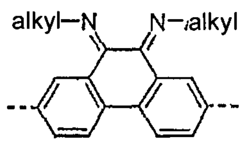

formula (143)

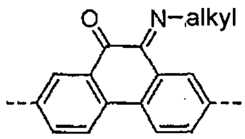

formula (144)

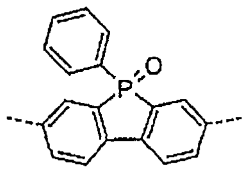

formula (145)

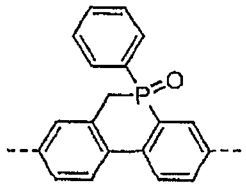

formula (146)

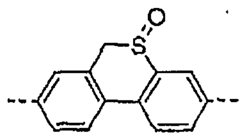

formula (147)

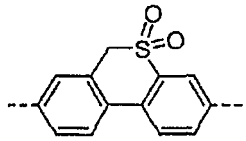

formula (148)

which may be substituted or unsubstituted.

5. Organic semiconductors according to one or more of Claims 1 to 4, **characterised in that** the polymers are selected from the classes of the aromatic polyketones, aromatic polyphosphine oxides or aromatic polysulfones, each of which may also be substituted for better solubility, the polycarboxylic acid derivatives, main-chain polyesters, side-chain polyesters, poly(glycolic acids), poly(lactic acids), poly(ε-caprolactones), polyacrylates, poly(hydroxybenzoic acids), poly(alkylene terephthalates), polycarboxylic anhydrides, polyamides, poly(ε-caprolactams), polypeptides, polyaramids, polybenzamides, polyimides, poly(amide-imides), poly(ester-imides), poly(ether-imides), polycarbonates, poly(ester-co-carbonates), poly(isocyanurates), polyurethanes, polyester-polyurethanes, poly(terephthalates), poly(acrylates), poly(phenyl acrylates), poly(cyanoacrylates), poly(vinyl esters), poly(vinyl acetates), side-chain polyphosphine oxides, polyether ketones (PEK), polyether sulfones, polysulfonamides, polysulfonimides, poly(vinyl ketones), aromatic polyvinyl ketones, substituted or unsubstituted poly(vinylbenzophenones), polystyrene-analogous ketones, polycarbazenes, polynitriles, polyisonitriles, polystyrene, PVK (polyvinylcarbazole) or derivatives thereof.

6. Organic semiconductors according to one or more of Claims 1 to 5, **characterised in that** the triplet emitters contain metal atoms from groups 8 to 10 of the Periodic Table of the Elements.

7. Organic semiconductors according to one or more of Claims 1 to 6, **characterised in that** further molecules, which may be of low molecular weight, oligomeric, dendritic or polymeric, preferably compounds containing structural units L=X or structural units of the formulae (1) to (5), are admixed with the organic semiconductors.

8. Use of an organic semiconductor according to one or more of Claims 1 to 7 in organic light-emitting diodes (PLEDs), organic solar cells (O-SCs), organic laser diodes (O-lasers) or in non-linear optics.

9. Electronic component which comprises one or more active layers, where at least one of these active layers comprises one or more organic semiconductors according to one or more of Claims 1 to 7.

10. Electronic component according to Claim 9, **characterised in that** it is an organic light-emitting diode, an organic solar cell or an organic laser diode.

**Revendications**

1. Semiconducteurs organiques comprenant :

(A) 0,5 - 98,9% en poids d'un quelconque polymère non conjugué souhaité (POLY3),
(B) 1 - 99% en poids d'au moins un composé (COMP1) qui contient au moins une unité structurelle L=X et qui dispose de la capacité de former des couches similaires à du verre à température ambiante, dans lesquels ce qui suit s'applique aux symboles utilisés :

L est, pour chaque occurrence, de manière identique ou différente, $(R^1)(R^2)C$, $(R^1)P$, $(R^1)As$, $(R^1)Sb$, $(R^1)Bi$, $(R^1)(R^2)(R^3)P$, $(R^1)(R^2)(R^3)As$, $(R^1)(R^2)(R^3)Sb$, $(R^1)(R^2)(R^3)Bi$, $(R^1)(R^2)S$, $(R^1)(R^2)Se$, $(R^1)(R^2)Te$, $(R^1)(R^2)S(=O)$, $(R^1)(R^2)Se(=O)$ ou $(R^1)(R^2)Te(=O)$ ;
X est, pour chaque occurrence, de manière identique ou différente, O, S, Se ou N-$R^4$, étant entendu que X n'est ni S, ni Se si L représente S, Se ou Te ;
$R^1$, $R^2$, $R^3$ sont, pour chaque occurrence, de manière identique ou différente, H, F, CN, un groupe alkyle, alcoxy ou thioalcoxy en chaîne droite, ramifié ou cyclique comportant 1 à 40 atome(s) de C, lequel peut être substitué par $R^5$ ou peut également être non substitué, où un ou plusieurs atome(s) de H peut/peuvent être remplacé(s) par F, Cl, Br, I, CN ou $NO_2$, ou un système de cycle aromatique ou hétéroaromatique comportant 1 à 40 atome(s) de C, lequel peut être substitué par un radical ou plusieurs radicaux $R^5$, où deux substituants $R^1$, $R^2$ et/ou $R^3$ ou plus peuvent également former un système de cycle aliphatique ou aromatique monocyclique ou polycyclique avec un autre ; tous les substituants $R^1$ à $R^3$ sur une seule unité structurelle ne doivent ici être ni H, ni F ; les groupes $R^1$ à $R^3$ peuvent en outre comporter en option des liaisons sur le polymère ;
$R^4$ est, pour chaque occurrence, de manière identique ou différente, une chaîne alkyle ou alcoxy en chaîne droite, ramifiée ou cyclique comportant 1 à 22 atome(s) de C, où un ou plusieurs atome(s) de C non adjacents peut/peuvent être remplacé(s) par $-R^6C=CR^6-$, $-C\equiv C-$, $Si(R^6)_2$, $Ge(R^6)_2$, $Sn(R^6)_2$, $-NR^6-$, -O-, -S-, -CO-O-, -O-CO-O-, où un ou plusieurs atome(s) de H peut/peuvent être remplacé(s) par fluor, un groupe aryle, hétéroaryle ou aryloxy comportant 1 à 40 atome(s) de C, lequel peut être substitué par un radical ou plusieurs radicaux $R^6$, ou OH ou $N(R^5)_2$ ;
$R^5$ est, pour chaque occurrence, de manière identique ou différente, $R^4$ ou CN, $B(R^6)_2$ ou $Si(R^6)_3$ ;
$R^6$ est, pour chaque occurrence, de manière identique ou différente, H ou un radical hydrocarbone aliphatique ou aromatique comportant 1 à 20 atome(s) de C ;

et
(C) 0,1 - 95% en poids d'un ou de plusieurs émetteur(s) triplet(s) (TRIP1), étant entendu que des mélanges de deux polymères selon lesquels un polymère contient des émetteurs triplets liés de façon covalente et l'autre est un copolymère comprenant des unités TPD et des unités de diphényl sulfone éther ou de diphényl cétone éther sont exclus ; et en outre, étant entendu que des polymères contenant d'une part des émetteurs triplets liés de façon covalente et d'autre part des unités de la formule (a) sont exclus de l'invention :

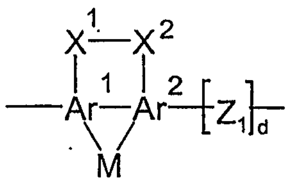
formule (a) (a)

dans laquelle $Ar^1$ et $Ar^2$, chacun de manière indépendante, représentent un groupe hydrocarbone aromatique tétravalent ou un groupe hétérocyclique tétravalent ;

l'une des unités $X^1$ et $X^2$ représente C(=O) ou $C(R^1)(R^2)$ et l'autre représente O, S, C(=O), S(=O), $SO_2$, $Si(R^3)(R^4)$, $N(R^5)$, $B(R^6)$, $P(R^7)$ ou $P(=O)(R^8)$ ;
où, dans la formule (a), les radicaux $R^1$, $R^2$, $R^3$, $R^4$, $R^5$, $R^6$, $R^7$ et $R^8$ représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;
M représente un groupe qui est représenté par la formule (b), la formule (c) ou la formule (d),

$$-Y^1\text{-}Y^2- \qquad \text{formule (b)}$$

dans laquelle $Y^1$ et $Y^2$ représentent, chacun de manière indépendante, O, S, C(=O), S(=O), $SO_2$, $C(R^9)(R^{10})$, $Si(R^{11})(R^{12})$, $N(R^{13})$, $B(R^{14})$, $P(R^{15})$ ou $P(=O)(R^{16})$,
où, dans la formule (b), les radicaux $R^9$, $R^{10}$, $R^{11}$, $R^{12}$, $R^{13}$, $R^{14}$, $R^{15}$ et $R^{16}$ représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;
où $Y^1$ et $Y^2$ ne sont pas identique si $Y^1$ n'est ni $C(R^9)(R^{10})$, ni $Si(R^{11})(R^{12})$ ;

$$-Y^3\text{-}Y^4- \qquad \text{formula (c)}$$

dans laquelle $Y^3$ et $Y^4$ représentent, chacun de manière indépendante, N, B, P, $C(R^{17})$ ou $Si(R^{18})$ ;
où, dans la formule (c), les radicaux $R^{17}$ et $R^{18}$ représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;

$$-Y^5 \qquad \text{formula (d)}$$

dans laquelle $Y^5$ représente O, S, C(=O), S(=O), $SO_2$, $C(R^{19})(R^{20})$, $Si(R^{21})(R^{22})$, $N(R^{23})$, $B(R^{24})$, $P(R^{25})$ ou $P(=O)(R^{26})$ ;
où, dans la formule (d), les radicaux $R^{19}$, $R^{20}$, $R^{21}$, $R^{22}$, $R^{23}$, $R^{24}$, $R^{25}$ et $R^{26}$ représentent, chacun de manière indépendante, un atome d'hydrogène, un atome d'halogène, un groupe alkyle, un groupe alcoxy, un groupe alkylthio, un groupe alkylamino, un groupe aryle, un groupe aryloxy, un groupe arylthio, un groupe arylamino, un groupe arylalkyle, un groupe arylalcoxy, un groupe arylalkylthio, un groupe arylalkylamino, un groupe acyle, un groupe acyloxy, un groupe amide, un groupe imine, un groupe silyle substitué, un groupe silyloxy substitué, un groupe silylthio substitué, un groupe silylamino substitué, un groupe hétérocyclique monovalent, un groupe arylalkényle, un groupe aryléthynyle ou un groupe cyano ;
$Z_1$ représente $-CR^{36}=CR^{37}-$ ou $-C\equiv C-$; $R^{36}$ et $R^{37}$ représentent, chacun de manière indépendante, un atome d'hydrogène, un groupe alkyle, un groupe aryle, un groupe hétérocyclique monovalent ou un groupe cyano ;
d représente 0 ou 1.

2. Semiconducteurs organiques selon la revendication 1, **caractérisés en ce que** les unités structurelles L=X sont choisies parmi les formules (1) à (5) :

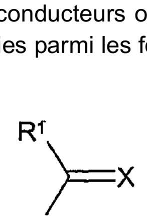
formule (1)

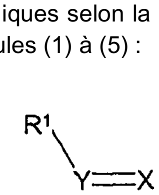
formule (2)

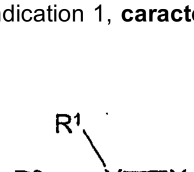
formule (3)

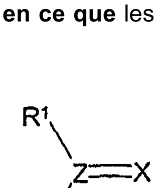
formule (4)

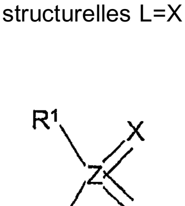
formule (5)

dans lesquelles les symboles utilisés présentent les significations qui suivent :

X est, pour chaque occurrence, de manière identique ou différente, O, S, Se ou N-$R^4$, étant entendu que X ne

peut être ni S, ni Se pour les formules (4) et (5) ;
Y est, pour chaque occurrence, de manière identique ou différente, P, As, Sb ou Bi ;
Z est, pour chaque occurrence, de manière identique ou différente, S, Se ou Te ;
$R^1$ à $R^6$ présentent la même signification que décrit sous la revendication 1.

3. Semiconducteurs organiques selon la revendication 1 ou 2, **caractérisés en ce que** les polymères POLY3 contiennent d'autres éléments structurels.

4. Semiconducteurs organiques selon une ou plusieurs des revendications 1 à 3, **caractérisés en ce que** le composé (COMP1) contient des éléments structurels L=X ou des éléments structurels des formules (1) à (5) choisis parmi les formules (6) à (148) :

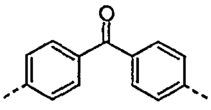
(6)
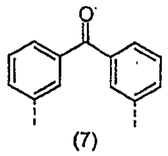
(7)
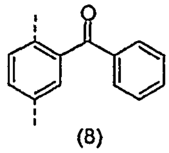
(8)
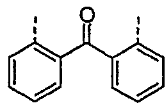
(9)
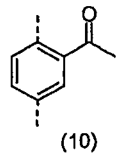
(10)

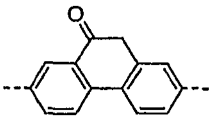
(11)
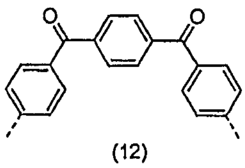
(12)
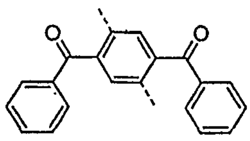
(13)
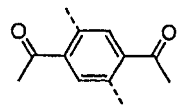
(14)
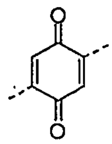
(15)

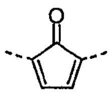
(16)
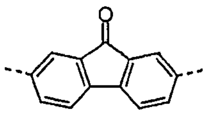
(17)
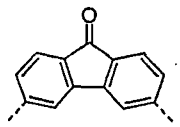
(18)
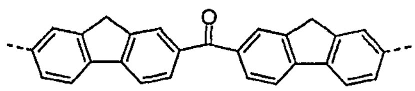
(19)

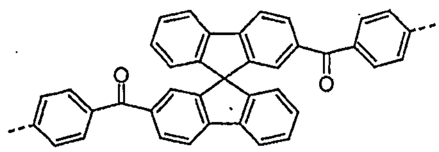
(20)
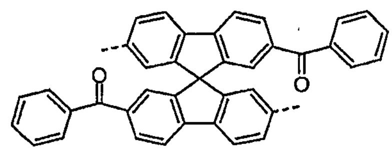
(21)

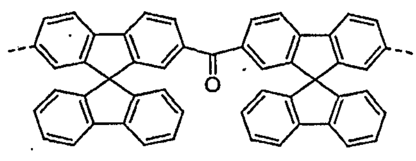
(22)
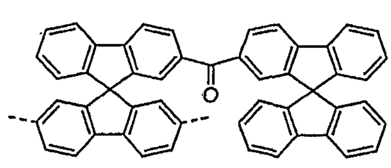
(23)

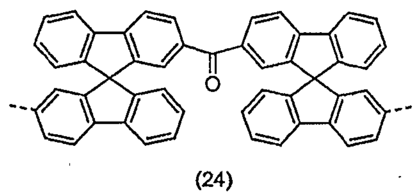
(24)
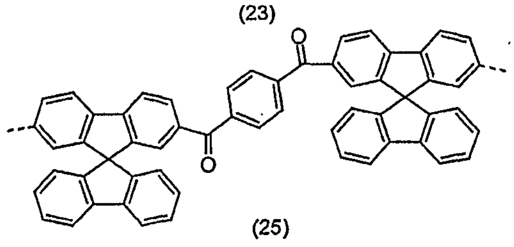
(25)

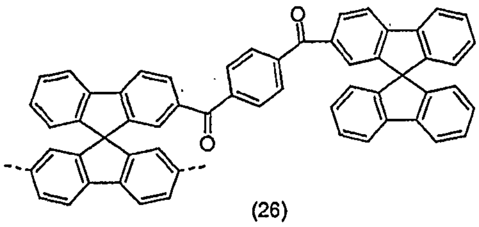
(26)

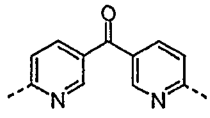
(27)

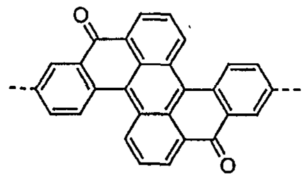
(28)

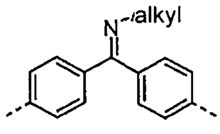
(29)

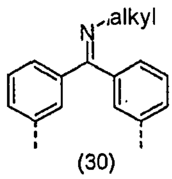
(30)

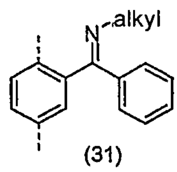
(31)

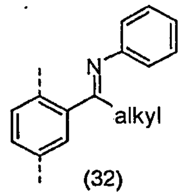
(32)

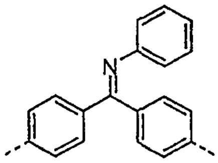
(33)

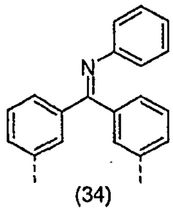
(34)

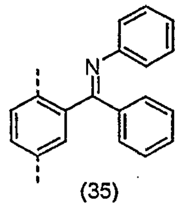
(35)

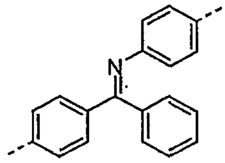
(36)

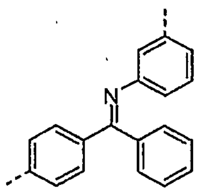
(37)

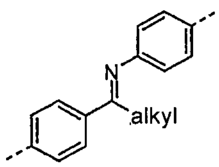
(38)

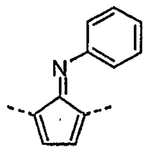
(39)

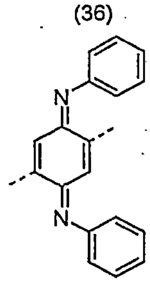
(40)

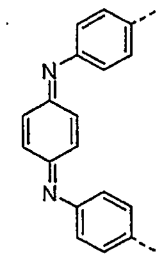
(41)

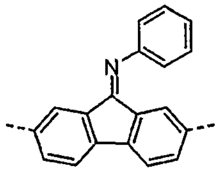
(42)

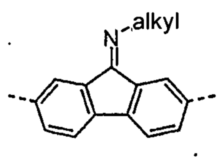
(43)

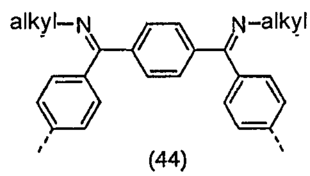
(44)

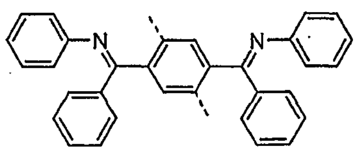
(45)

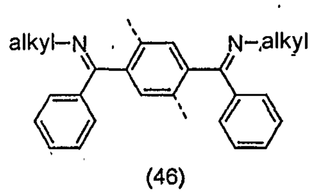
(46)

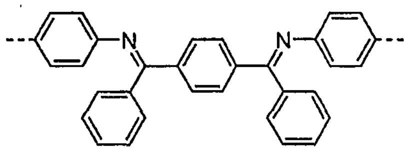
(47)

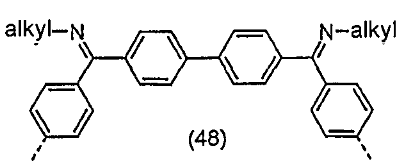

(48)

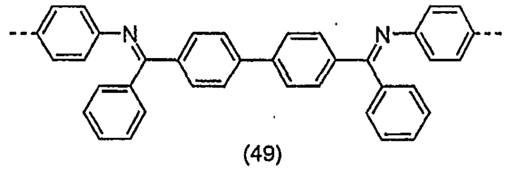

(49)

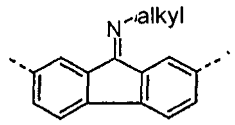

(50)

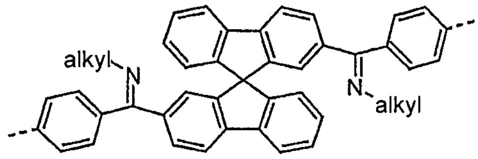

(51)

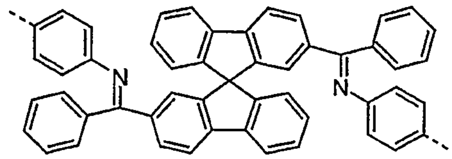

(52)

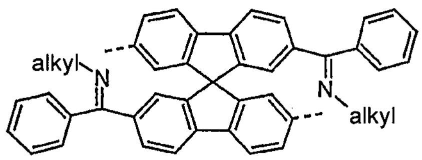

(53)

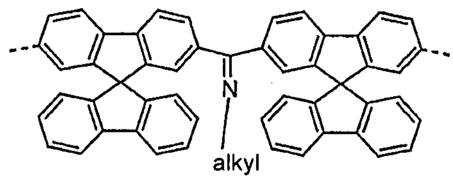

(54)

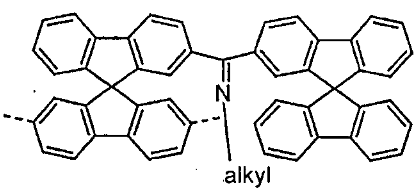

(55)

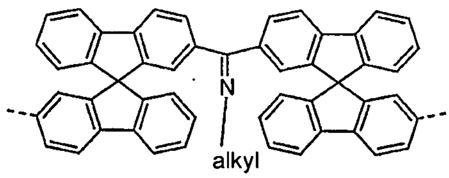

(56)

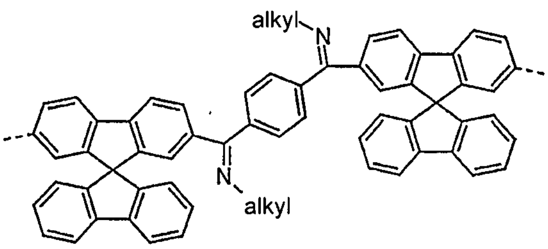

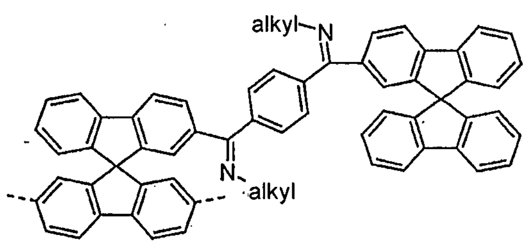

(57) (58)

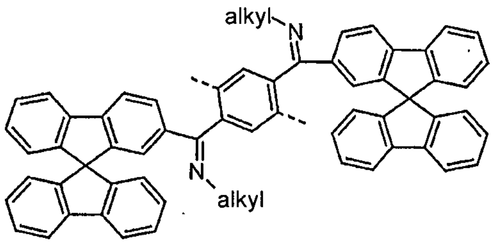

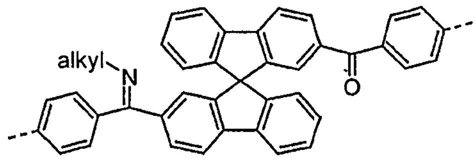

(60)

(59)

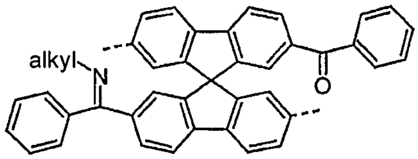

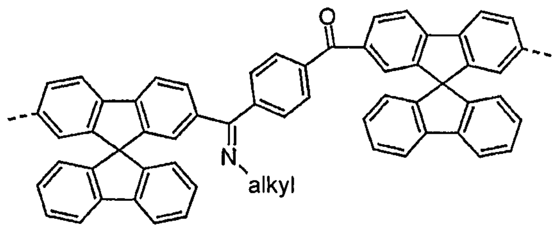

(61) (62)

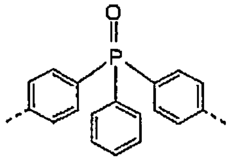

(63)

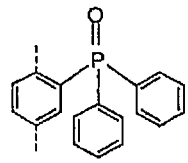

(64)

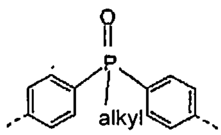

(65)

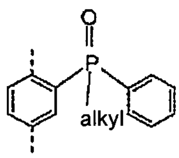

(66)

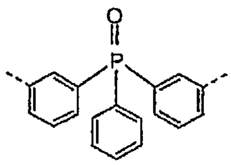

(67)

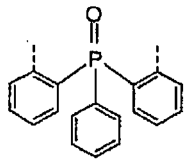

(68)

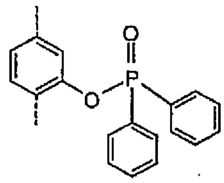

(69)

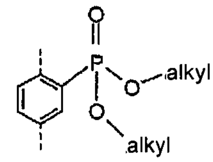

(70)

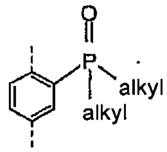

(71)

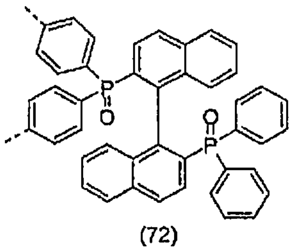

(72)

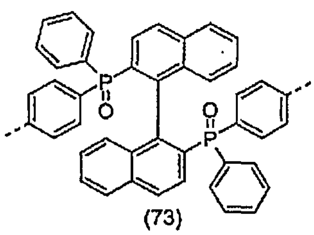

(73)

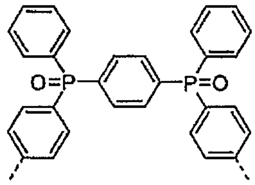

(74)

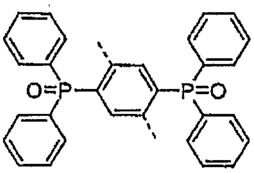

(75)

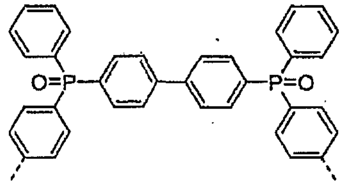

(76)

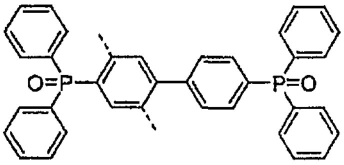

(77)

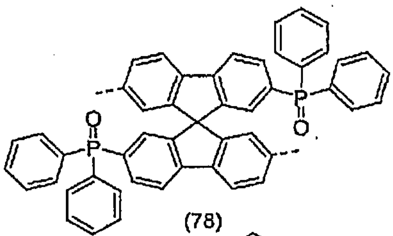

(78)

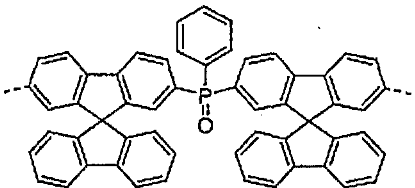

(79)

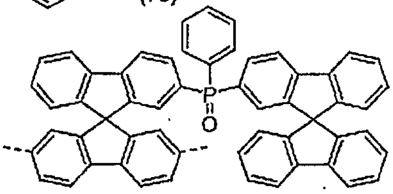

(80)

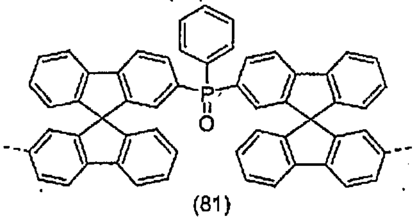

(81)

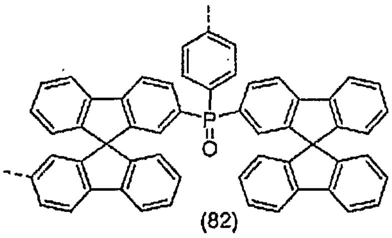

(82)

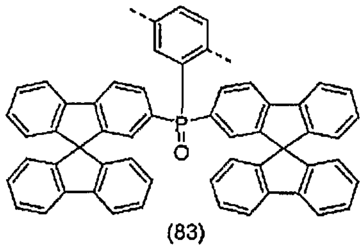

(83)

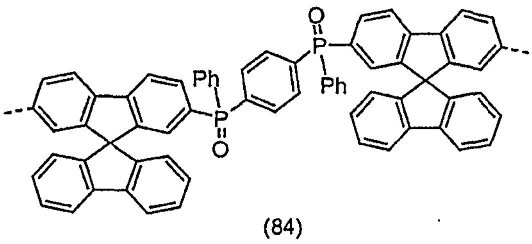

(84)

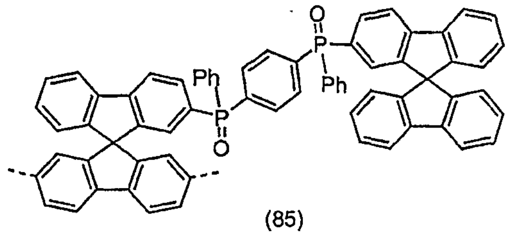

(85)

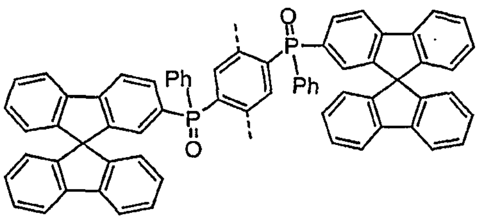

(86)

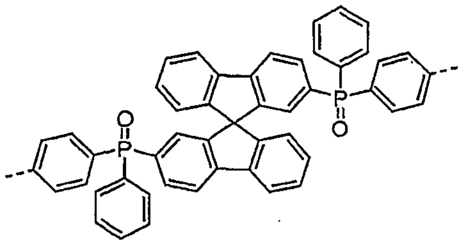

(87)

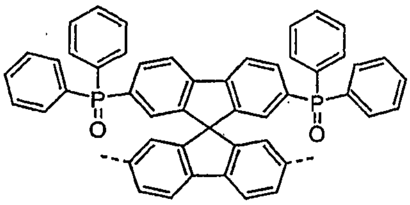
(88)

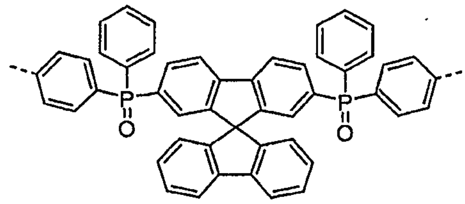
(89)

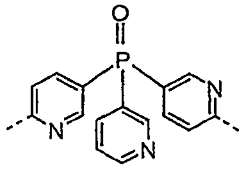
(90)

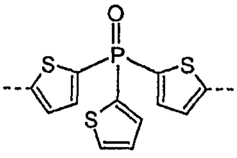
(91)

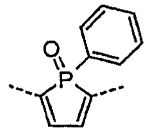
(92)

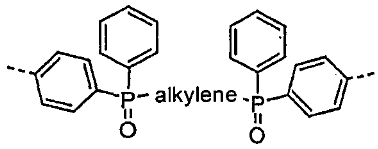
(93)

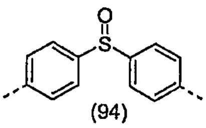
(94)

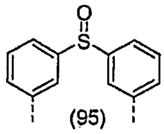
(95)

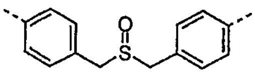
(96)

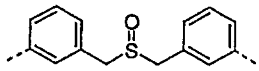
(97)

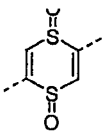
(98)

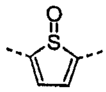
(99)

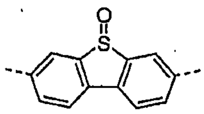
(100)

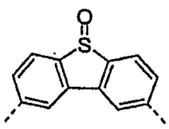
(101)

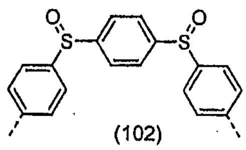
(102)

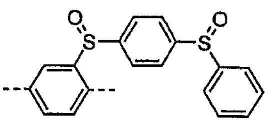
(103)

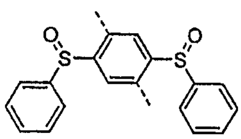
(104)

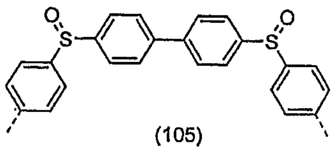
(105)

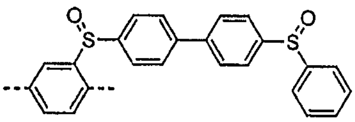
(106)

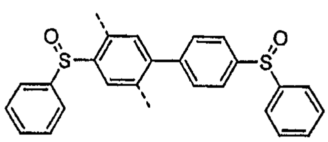
(107)

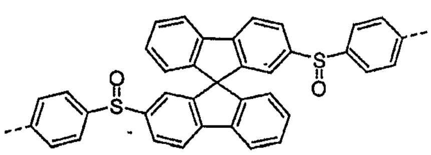
(108)

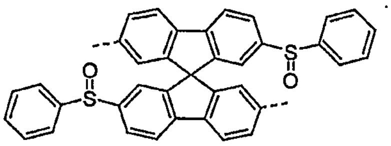

(109)

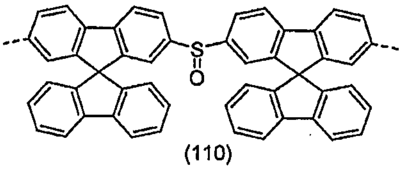

(110)

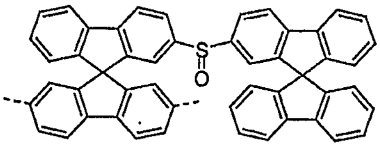

(111)

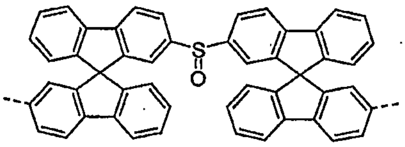

(112)

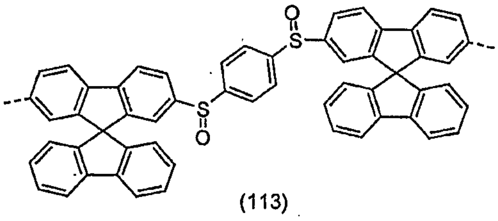

(113)

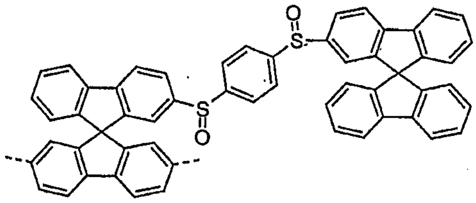

(114)

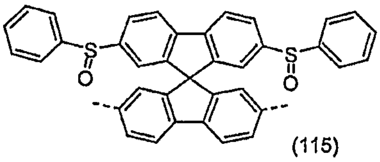

(115)

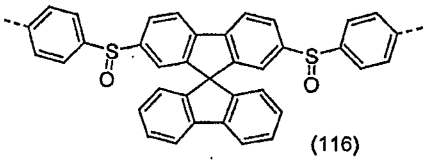

(116)

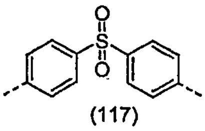

(117)

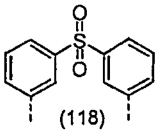

(118)

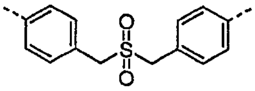

(119)

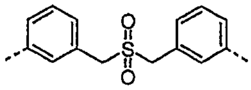

(120)

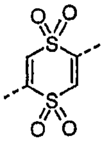

(121)

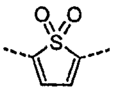

(122)

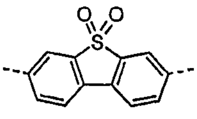

(123)

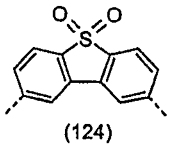

(124)

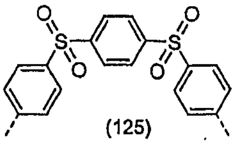

(125)

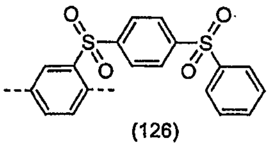

(126)

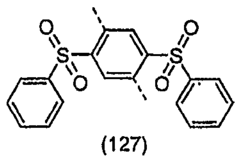

(127)

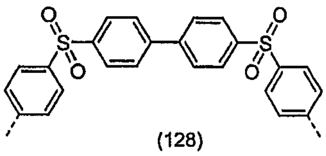

(128)

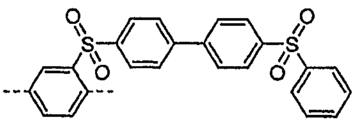

(129)

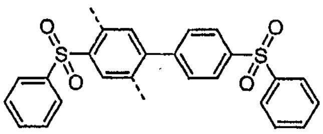

(130)

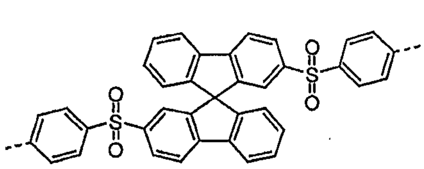

(131)

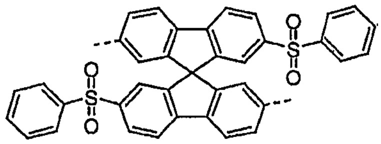

(132)

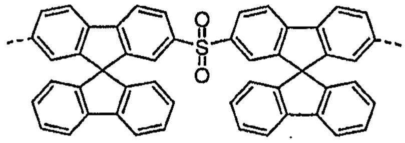

(133)

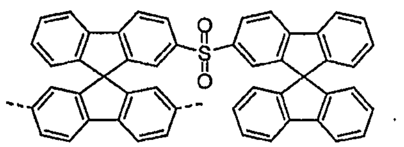

(134)

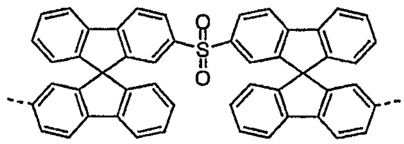

(135)

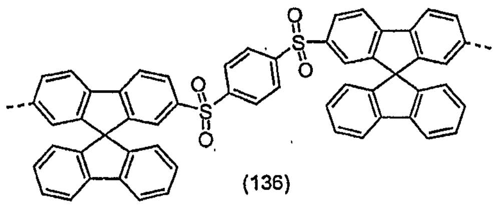

(136)

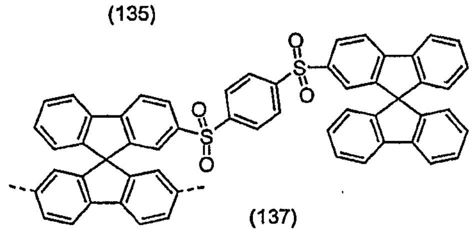

(137)

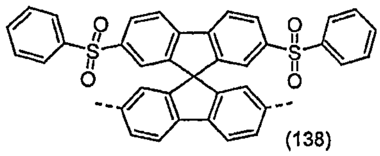

(138)

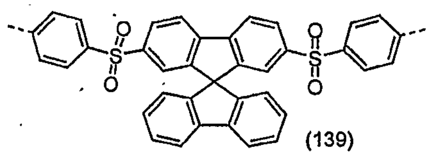

(139)

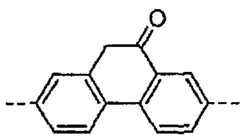

formule (140)

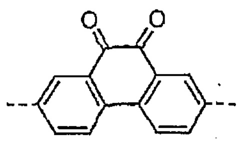

formule (141)

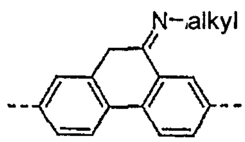

formule (142)

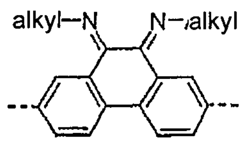

formule (143)

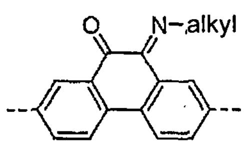

formule (144)

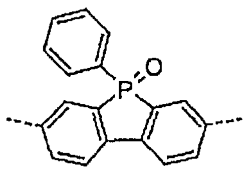

formule (145)

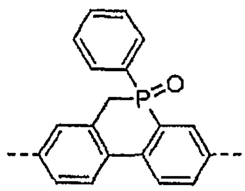

formule (146)

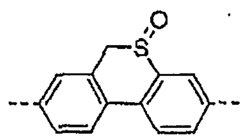

formule (147)

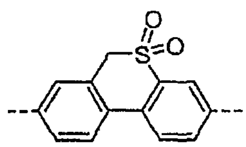

formule (148)

qui peuvent être substitués ou non substitués.

**5.** Semiconducteurs organiques selon une ou plusieurs des revendications 1 à 4, **caractérisés en ce que** les polymères sont choisis parmi les classes constituées par les polycétones aromatiques, les oxydes de polyphosphine aromatiques et les polysulfones aromatiques, dont chacun peut également être substitué pour une meilleure solubilité, les dérivés d'acide polycarboxylique, les polyesters en chaîne principale, les polyesters en chaîne latérale, les poly(acides glycoliques), les poly(acides lactiques), les poly(ε-caprolactones), les polyacrylates, les poly(acides hydroxybenzoïques), les poly(alkylène téréphtalates), les anhydrides polycarboxyliques, les polyamides, les poly(ε-caprolactames), les polypeptides, les polyaramides, les polybenzamides, les polyimides, les poly(amide-imides), les poly(ester-imides), les poly(étherimides), les polycarbonates, les poly(ester-co-carbonates), les poly(isocyanurates), les polyuréthanes, les polyester-polyuréthanes, les poly(téréphtalates), les poly(acrylates), les poly(phényl acrylates), les poly(cyanoacrylates), les poly(vinyl esters), les poly(vinyl acétates), les oxydes de polyphosphine en chaîne latérale, les polyéther cétones (PEK), les polyéther sulfones, les polysulfonamides, les polysulfonimides, les poly(vinyl cétones), les polyvinyl cétones aromatiques, et, en mode substitué ou non substitué, les poly(vinylbenzophénones), les cétones analogues au polystyrène, les polycarbazènes, les polynitriles, les polyisonitriles, le polystyrène, le PVK (polyvinylcarbazole) ou leurs dérivés.

**6.** Semiconducteurs organiques selon une ou plusieurs des revendications 1 à 5, **caractérisés en ce que** les émetteurs triplets contiennent des atomes de métaux pris parmi les groupes 8 à 10 dans le Tableau Périodique des Eléments.

**7.** Semiconducteurs organiques selon une ou plusieurs des revendications 1 à 6, **caractérisés en ce que** d'autres molécules, qui peuvent être des composés de préférence oligomériques, dendritiques ou polymériques de poids moléculaire faible contenant des unités structurelles L=X ou des unités structurelles des formules (1) à (5), sont ajoutées par mélange avec les semiconducteurs organiques.

**8.** Utilisation d'un semiconducteur organique selon une ou plusieurs des revendications 1 à 7 dans des diodes émettrices de lumière organiques (PLED), des cellules solaires organiques (O-SC), des diodes laser organiques (O-laser) ou dans des optiques non linéaires.

**9.** Composant électronique qui comprend une ou plusieurs couche(s) active(s), où au moins l'une de ces couches actives comprend un ou plusieurs semiconducteur(s) organique(s) selon une ou plusieurs des revendications 1 à 7.

**10.** Composant électronique selon la revendication 9, **caractérisé en ce qu'**il s'agit d'une diode émettrice de lumière organique, d'une cellule solaire organique ou d'une diode laser organique.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 9013148 A
- DE 10317556
- DE 10330761
- WO 04070772 A
- DE 10328627
- WO 0191203 A2
- WO 03099901 A
- US 03022908 A
- US 03224208 A
- WO 03020790 A
- DE 10337346
- WO 03048225 A
- WO 04022626 A
- WO 02068435 A
- WO 02081488 A
- EP 1239526 A
- WO 04026886 A
- WO 9921935 A
- WO 01059030 A
- WO 02066552 A
- WO 04037887 A
- WO 02077060 A
- WO 03048224 A


### In der Beschreibung aufgeführte Nicht-Patentliteratur


- **M. A. BALDO et al.** *Appl. Phys. Lett.,* 1999, vol. 75, 4-6
- **V. CLEAVE et al.** Harvesting Singlet and Triplet Energy in Polymer LEDs. *Adv. Mater.,* 1999, vol. 11 (4), 285-288
- *Helv. Chim. Acta,* 1999, vol. 82, 338-346